(19) Europäisches Patentamt / European Patent Office / Office européen des brevets

(11) **EP 4 711 988 A2**

(12) **EUROPEAN PATENT APPLICATION**

(43) Date of publication:
**18.03.2026 Bulletin 2026/12**

(21) Application number: **26155542.9**

(22) Date of filing: **11.04.2025**

(51) International Patent Classification (IPC):
***G06N 10/40*** *(2022.01)*

(52) Cooperative Patent Classification (CPC):
**G06N 10/40; G06N 10/20; G06N 10/60;
G06N 10/80;** G06N 10/70

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **19.04.2024 US 202418641037**

(62) Document number(s) of the earlier application(s) in
accordance with Art. 76 EPC:
**25169965.8 / 4 636 657**

(71) Applicant: **Microsoft Technology Licensing, LLC
Redmond, WA 98052-6399 (US)**

(72) Inventors:
• **BOUTIN, Samuel
Redmond, 98052-6399 (US)**

• **SILVA, Marcus Palmer da
Redmond, 98052-6399 (US)**
• **BAUER, Roman Bela
Redmond, 98052-6399 (US)**
• **KARZIG, Torsten
Redmond, 98052-6399 (US)**
• **KNAPP, Christina Paulsen
Redmond, 98052-6399 (US)**

(74) Representative: **Page White Farrer
Bedford House
21a John Street
London WC1N 2BF (GB)**

Remarks:
This application was filed on 30-01-2026 as a
divisional application to the application mentioned
under INID code 62.

(54) **MEASUREMENT-BASED QUBIT BENCHMARKING**

(57) A computing system comprises a quantum computing device including a plurality of logical qubits that each include a respective plurality of physical qubits; and a controller. The controller is configured to determine an error metric value of a qubit error metric for a logical qubit of the plurality of logical qubits at least in part by: at the logical qubit, performing a Pauli measurement sequence including a plurality of Pauli measurements; and computing the error metric value based at least in part on respective results of the plurality of Pauli measurements. Computing the error metric value includes computing respective assignment error probabilities of the Pauli measurements; and/or computing respective mutual unbiasedness values of pairs of non-commuting Pauli measurements that are adjacent in the Pauli measurement sequence. The controller is further configured to output the error metric value.

FIG. 16A

EP 4 711 988 A2

**Description**

BACKGROUND

In quantum computing, computations are performed by manipulating data stored in the form of qubits. Whereas conventional computer memory holds digital data in an array of bits and enacts bit-wise logic operations, a quantum computer holds data in an array of qubits and operates quantum-mechanically on the qubits in order to implement computations. By performing operations on qubits instead of classical bits, some computational tasks may be performed with lower computational complexity.

Error in quantum computations presents a challenge for quantum computing device development and implementation. Noise (e.g., thermal noise) at the quantum computing device may affect the outcomes of measurements and may accordingly produce errors in computations. Errors may also, for example, be caused by device manufacturing defects. In order to make quantum computing devices more robust to potential sources of error, existing quantum computing devices are cooled to low temperatures. In addition, error correction protocols are implemented at existing quantum computing devices. These error correction protocols utilize collections of physical qubits to form logical qubits that are used to perform computations. While these approaches do not completely eliminate error, they may allow computational tasks to be performed at a quantum computing device.

SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

According to one aspect of the present disclosure, a computing system is provided, including a topological quantum computing device including a plurality of Majorana islands that form a plurality of physical qubits. The computing system further includes a controller configured to, for each of the physical qubits, in a measurement-based qubit benchmarking (MBQB) stage, determine an error metric value of a qubit error metric associated with the physical qubit. Determining the error metric value includes, at the Majorana island that forms the physical qubit, performing a Pauli measurement sequence including a plurality of Pauli measurements. Determining the error metric value further includes computing the error metric value based at least in part on respective results of the plurality of Pauli measurements. The controller is further configured to output the error metric value.

BRIEF DESCRIPTION OF THE DRAWINGS

FIG. 1 schematically shows an example computing system that includes a topological quantum computing device coupled to a controller, according to one example embodiment.

FIGS. 2-7 schematically show example configurations of Majorana qubits that may be included in the topological quantum computing device, according to the example of FIG. 1.

FIG. 8 schematically shows the computing system during a topological gap protocol (TGP) stage in which the controller is configured to set a plurality of island parameters of a Majorana island, according to the example of FIG. 1.

FIG. 9 schematically shows the computing system when the controller is further configured to perform a Majorana parity readout (MPR) stage subsequently to performing the TGP stage, according to the example of FIG. 1.

FIGS. 10A-10B schematically show the computing system when the controller is further configured to perform a measurement-based qubit benchmarking (MBQB) stage, according to the example of FIG. 1.

FIG. 11 schematically shows the controller during computation of assignment error probabilities and mutual unbiasedness values, according to the example of FIGS. 10A-10B.

FIGS. 12A-12B schematically show the computing system in an example in which the controller is further configured to compute a false positive rate of the error metric value, according to the example of FIGS. 10A-10B.

FIG. 13 schematically shows the computing system when the TGP stage, the MPR stage, and the MBQB stage are performed, according to the example of FIGS. 10A-10B.

FIGS. 14A-14B schematically shows an example computing system, including a quantum computing device and a controller, when an MBQB stage is performed for logical qubits, according to another example embodiment.

FIG. 15A schematically shows a flowchart of a method for use with a computing system that includes a topological quantum computing device and a controller, according to the example of FIG. 1.

FIGS. 15B-15F show additional steps of the method of FIG. 15A that may be performed in some examples.

FIG. 16A shows a flowchart of a method for use with a computing system to benchmark the error properties of logical qubits included in a quantum computing device, according to the example of FIGS. 14A-14B.

FIG. 16B shows additional steps of the method of FIG. 16A that may be performed in examples in which the physical qubits that form the logical qubits are measurement-based qubits.

FIG. 17 schematically shows an example computing system that can enact one or more of the methods and processes described above, according to the example of FIG. 1.

DETAILED DESCRIPTION

The following discussion provides devices and methods that can be used to benchmark the error properties of a quantum computing device. In addition, the following discussion relates to the tuning of quantum computing device parameters to values at which computations may be performed. The device parameter tuning and error benchmarking processes may, for example, be performed to calibrate and test quantum hardware after device manufacturing and before end use of the quantum computing device. Additionally or alternatively, the device parameter tuning and error benchmarking processes may be performed at a predefined time interval in order to maintain qubit functionality and check the error properties of the quantum computing device.

The parameter tuning and error benchmarking approaches discussed below are, in some examples, performed at a topological quantum computing device. In a topological quantum computing device, the quantum state held in each qubit is a state of two or more quasiparticles or defects with topological charge. Transformations on the state encoded in pairs or collections of these "anyons" or "topological defects" are represented by stable braids of the worldlines in space- time. The topological quantum computing devices discussed in the examples provided below are measurement-based quantum computing devices in which the quantum states are controlled by measuring observables of the topological charges of the anyons or topological defects. For example, these observables may be the joint fermionic parity operators of Majorana zero modes.

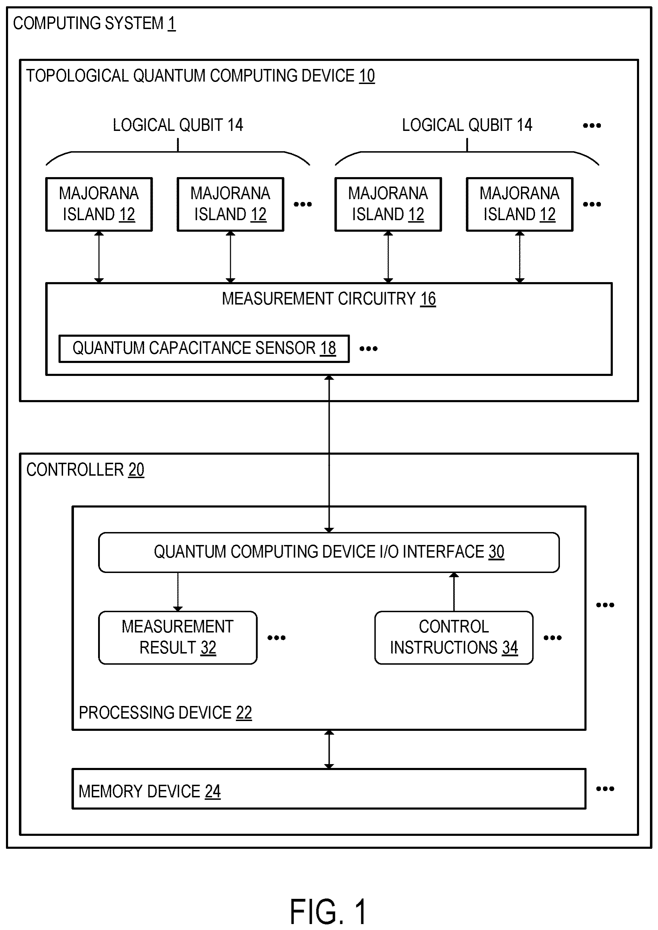

FIG. 1 schematically shows an example computing system 1 that includes a topological quantum computing device 10 coupled to a controller 20. The topological quantum computing device 10 shown in the example of FIG. 1 is a Majorana-based quantum computing device that includes a plurality of Majorana islands 12. As discussed in further detail below, the Majorana islands 12 are each configured to instantiate a plurality of Majorana zero modes (MZMs) that may be controlled in a topologically protected manner. Thus, the MZMs are used to form the physical qubits of the topological quantum computing device 10. Sets of these physical qubits are then used to form logical qubits 14, each of which includes a plurality of the Majorana islands 12 in the example of FIG. 1.

The topological quantum computing device 10 shown in the example of FIG. 1 further includes measurement circuitry 16. The measurement circuitry 16 is configured to measure observables of the physical qubits instantiated at the Majorana islands 12 and transmit the obtained measurement results 32 to the controller 20. For example, the measurement circuitry 16 may include a plurality of quantum capacitance sensors 18 configured to measure respective quantum capacitance values at components of the Majorana islands 12. The topological quantum computing device 10 may be tuned such that different quantum states of the MZMs correspond to different respective quantum capacitance values. For example, different topological charges of pairs of MZMs may correspond to different quantum capacitance values. Thus, the plurality of quantum capacitance sensors 18 may be configured to perform measurements of the topological charges to perform quantum computations.

The controller 20 is a classical computing device that is configured to communicate with the topological quantum computing device 10. The controller 20 depicted in the example of FIG. 1 includes one or more processing devices 22 and one or more memory devices 24. The one or more processing devices 22 may, for example, include one or more central processing units (CPUs), graphics processing units (GPUs), application-specific integrated circuits (ASICs), specialized hardware accelerators, and/or other types of processing devices. The one or more memory devices 24 may include one or more volatile memory devices and/or one or more non-volatile storage devices. In some examples, the functionality of the one or more processing devices 22 and/or the one or more memory devices 24 is distributed across a plurality of communicatively interconnected physical computing devices, such as a plurality of server computing devices located at a data center.

At the one or more processing devices 22, the controller 20 is configured to execute a quantum computing device input/output interface 30. The one or more processing devices 22 are configured to receive the measurement results 32 from the measurement circuitry 16 of the topological quantum computing device 10 via the quantum computing device input/output interface 30. In addition, the one or more processing devices 22 are configured to generate control instructions 34 for the topological quantum computing device 10 and to transmit the control instructions 34 to the topological quantum computing device 10 over the quantum computing device input/output interface 30. The control instructions 34 may include instructions to set one or more specific values of device parameters and/or to perform one or more specific measurements at the Majorana islands 12.

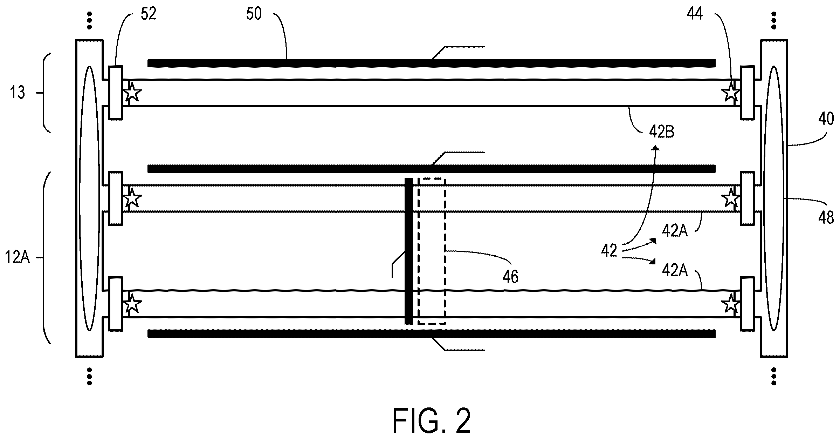

FIG. 2 schematically shows an example configuration of a Majorana island 12A that may be included in the topological quantum computing device 10 in some examples. The topological quantum computing device 10 includes a plurality of topological superconducting wires 42. In the example of FIG. 2, the Majorana island 12A includes two topological superconducting wires 42A coupled by a trivial superconductor 46. In addition, the example of FIG. 2 shows a coherent link 13 formed by a topological superconducting wire 42B. The topological superconducting wires 42 may, for example, be topological superconducting portions of hybrid superconductor-semiconductor wires that each include a semiconducting portion arranged in parallel to a superconducting portion. The Majorana island 12A further includes semiconductor regions 40 located at respective ends of the topological superconducting wires 42A. The semiconductor regions 40 may include respective quantum dots (QDs) 48.

The trivial superconductor 46 bridges the topological superconducting wires 42A that form the Majorana island 12A. For example, the trivial superconductor 46 may also be a superconducting portion of a hybrid superconductor-semiconductor wire. The trivial superconductor 46 is configured to exhibit non-topological superconductivity under normal operating conditions of the topological quantum computing device 10, whereas the topological superconducting wires 42 are configured to exhibit topological superconductivity under such conditions.

The Majorana island 12A of FIG. 2 includes a plurality of superconductor-semiconductor junctions 44 located at intersections between the topological superconducting wires 42 and the semiconductor regions 40. MZMs form adjacent to the superconductor-semiconductor junctions 44 during operation of the topological quantum computing device 10, as discussed in further detail below. Pairs of the superconductor-semiconductor junctions 44 are located at respective endpoints of each of the three topological superconducting wires 42. In the example of FIG. 2, the Majorana island 12A is a Majorana tetron that includes six superconductor-semiconductor junctions 44. The coherent link 13 shown in the example of FIG. 2 is used to facilitate measurement loops that include MZMs on both the left and the right sides of the Majorana island 12A.

The Majorana island 12A further includes a plurality of plunger gates 50 and a plurality of cutter gates 52. The plunger gates 50 and the cutter gates 52 are electrically controllable via the quantum computing device input/output interface 30, via which the controller 20 is configured to set respective gate voltages of the plunger gates 50 and cutter gates 52. In the example of FIG. 2, the plunger gates 50 are arranged parallel to the topological superconducting wires 42. The cutter gates 52 are located in the semiconductor regions 40 proximate to the superconductor-semiconductor junctions 44. The controller 20 is configured to control the cutter gates 52 to specify whether the superconductor-semiconductor junctions 44 are electrically coupled to the QDs 48 located in the adjacent semiconductor regions 40.

In the example of FIG. 2, the Majorana island 12A may be included among a plurality of Majorana islands 12A that are arranged in parallel and that share the semiconductor regions 40 with each other. In such examples, the Majorana islands 12A are separately controllable by setting respective voltages of the plunger gates 50 and the cutter gates 52.

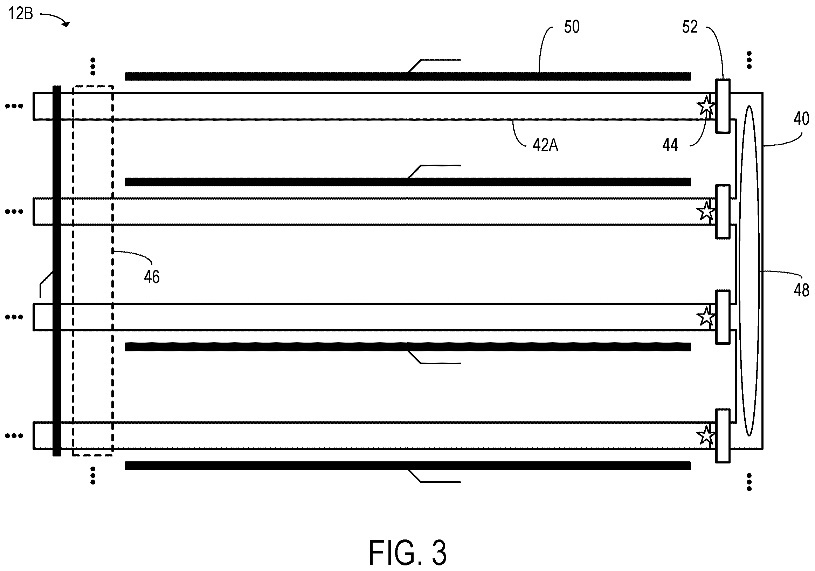

FIG. 3 schematically shows another example configuration of a Majorana island 12B. The Majorana island 12B of FIG. 3 is a Majorana tetron that includes four superconductor-semiconductor junctions 44 arranged on the surface of a shared semiconductor region 40. The superconductor-semiconductor junctions 44 are located at the ends of separate topological superconducting wires 42A in the example Majorana island 12B of FIG. 3. In the Majorana island 12B, the trivial superconductor 46 also extends across each of the topological superconducting wires 42A. Respective plunger gates 50 are arranged in parallel to the topological superconducting wires 42A. Respective cutter gates 52 are located in the semiconductor region 40 proximate to each of the superconductor-semiconductor junctions 44, such that the cutter gates 52 are configured to couple and decouple the superconductor-semiconductor junctions 44 and a QD 48 located in the semiconductor region 40.

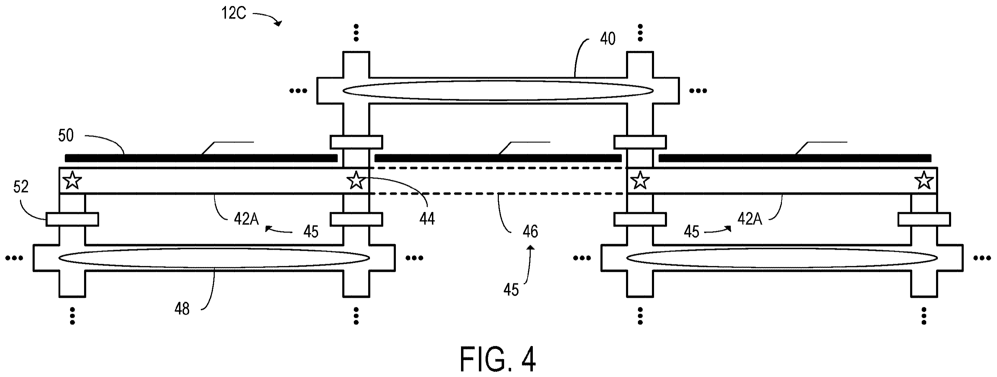

FIG. 4 schematically shows another example configuration of a Majorana island 12C. The Majorana island 12C of FIG. 4 is also a Majorana tetron. In the example Majorana island 12C of FIG. 4, pairs of superconductor-semiconductor junctions 44 are located at the respective endpoints of two topological superconducting wires 42A. The Majorana island 12C includes three semiconductor regions 40 that each include a respective QD 48. The trivial superconductor 46 is located proximate to respective superconductor-semiconductor junctions 44 of the two topological superconducting wires 42A and is arranged in a line with the topological superconducting wires 42A. The Majorana island 12C of FIG. 4 includes respective plunger gates 50 arranged in parallel to the topological superconducting wires 42A and further includes cutter gates 52 in the semiconductor regions 40 proximate to the superconductor-semiconductor junctions 44.

The Majorana island 12C may be included as a repeating unit in the topological quantum computing device 10, such that a plurality of instances of the Majorana island 12C are arranged in a line with each other. In this line of Majorana islands 12C, the topological superconducting wires 42A may alternate with the trivial superconductors 46 to form a line of central wire segments 45. The semiconductor regions 40 may alternate between a first side and a second side of the central wire segments 45.

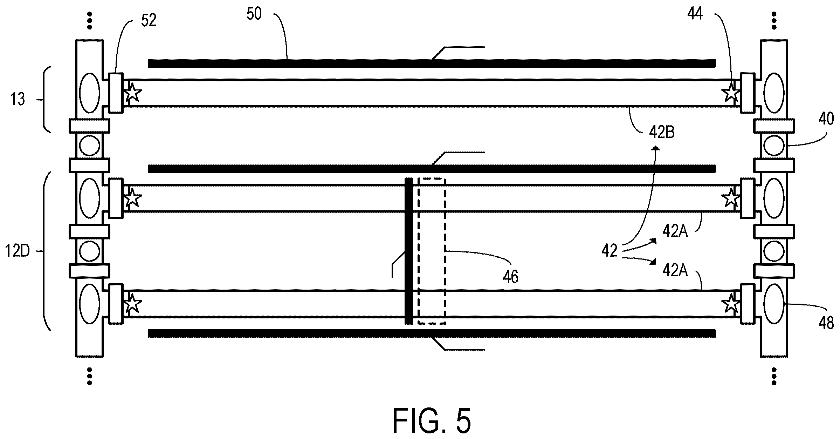

FIG. 5 schematically shows another example configuration of a Majorana island 12D. In the example of FIG. 5, the Majorana island 12D is a Majorana tetron with a similar configuration to that of FIG. 2, but with additional cutter gates 52 that form additional quantum dots 48 in the semiconductor regions 40. In addition, the configuration of FIG. 5 includes a coherent link 13 coupled to the Majorana tetron via the semiconductor regions 40. The semiconductor regions 40 on either side of the topological superconducting wires 42 each include an additional pair of cutter gates 52 between each pair of superconductor-semiconductor junctions 44. These additional cutter gates 52 form additional quantum dots 48 in the portions of the semiconductor regions 40 located between the superconductor-semiconductor junctions 44. The additional cutter gates 52 also form QDs 48 in the semiconductor regions 40 at the ends of the topological superconducting wires 42.

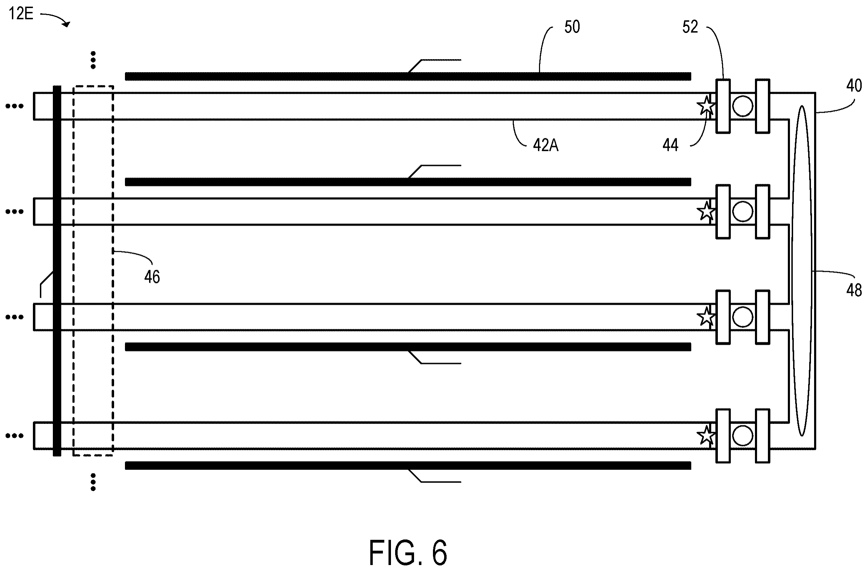

FIG. 6 schematically shows another example configuration of a Majorana island 12E. The Majorana island 12E shown in FIG. 6 is a Majorana tetron with a similar configuration to that of FIG. 3, but with additional cutter gates 52 in the portions of the semiconductor regions 40 proximate to the superconductor-semiconductor junctions 44. These additional cutter gates form additional QDs 48 that are located proximate to the superconductor-semiconductor junctions 44 and may be electrically coupled to those superconductor-semiconductor junctions 44.

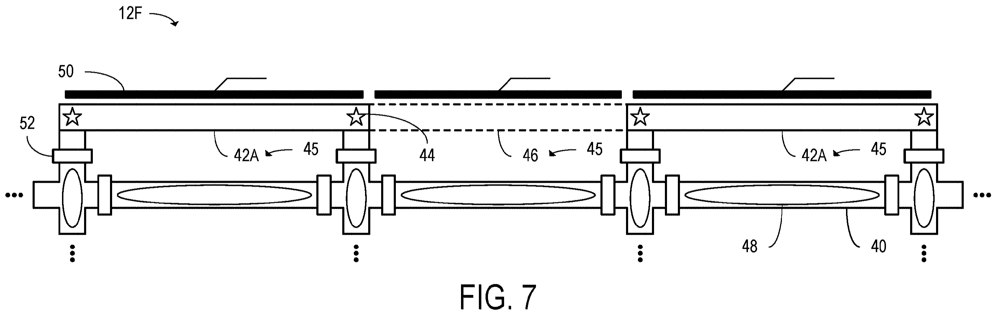

FIG. 7 schematically shows another example configuration of a Majorana island 12F. Similarly to the configuration of FIG. 4, the Majorana island 12F of FIG. 7 is a Majorana tetron that includes topological superconducting wires 42A and a trivial superconductor 46 that form a line of central wire segments 45. The Majorana island 12F includes a semiconductor region 40 connected to both of the topological superconducting wires 42A and arranged in parallel to the central wire segments 45. The semiconductor region 40 includes cutter gates 52 proximate to the superconductor-semiconductor junctions 44 located at the ends of the topological superconducting wires 42A. The semiconductor region 40 further includes additional cutter gates 52 located proximate to the cutter gates 52 that are proximate to the superconductor-semiconductor junctions 44. The cutter gates 52 are electrically controllable to form QDs 48 proximate to the ends of the topological superconducting wires 42A, and in portions of the semiconducting region 40 between the QDs 48 that are proximate to the ends of the topological superconducting wires 42A.

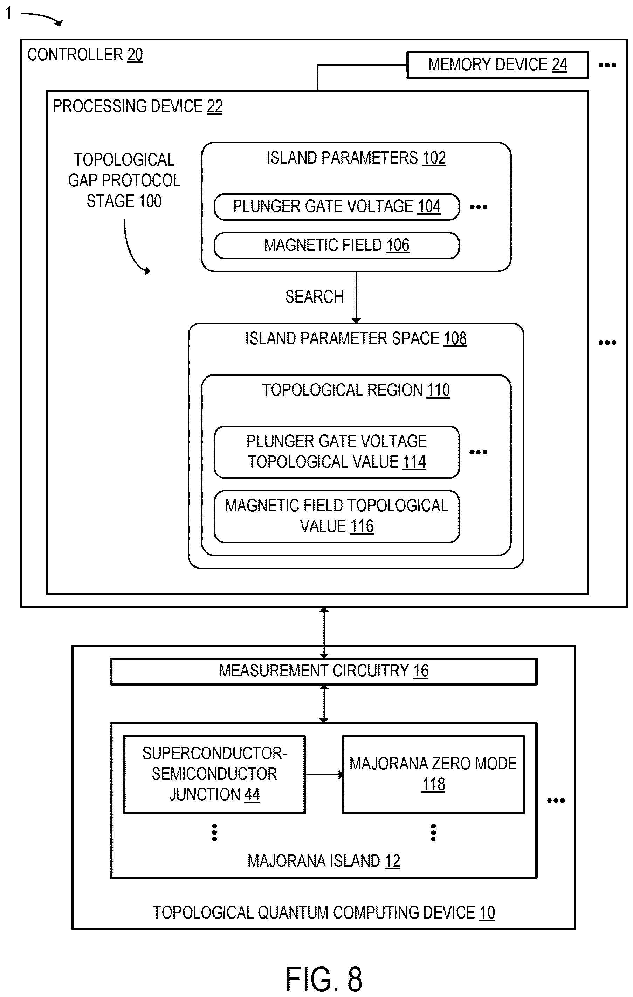

FIG. 8 schematically shows the computing system 1 during a topological gap protocol (TGP) stage 100 in which the controller 20 is configured to set a plurality of island parameters 102 of the Majorana island 12. The controller 20 may, for example, be configured to perform the TGP stage 100 for the plurality of Majorana islands 12 in parallel. The island parameters 102 may include a respective plurality of plunger gate voltages 104 of the plunger gates 50 included in the Majorana island 12. In addition, the island parameters 102 may further include a magnetic field 106 applied to the Majorana island 12. The magnetic field 106 may be a global parameter that is set for all the Majorana islands 12 included in the topological quantum computing device 10.

The island parameters 102 of the Majorana island 12 define an island parameter space 108. During the TGP stage 100, the controller 20 is configured to search over the island parameter space 108 for a topological region 110 in which the superconductor-semiconductor junctions 44 couple to MZMs 118. When the island parameters 102 are within the topological region 110, the plunger gate voltages 104 may have plunger gate voltage topological values 114. In addition, the magnetic field 106 may have a magnetic field topological value 116.

During the TGP stage 100, the controller 20 may be configured to set the trivial superconductor 46 to a plunger gate voltage 104 at which electron depletion occurs in the semiconducting portion of the hybrid superconductor-semiconductor wire that includes the trivial superconductor 46. In addition, the controller 20 may be further configured to operate the cutter gates 52 located proximate to the superconductor-semiconductor junctions 44 in a tunneling regime. The QDs 48 that are adjacent to the superconductor-semiconductor junctions 44 may be connected to respective electrical leads during the TGP stage 100. The pairs of superconductor-semiconductor junctions 44 included in the respective topological superconducting wires 42 may be decoupled from the adjacent QDs 48 during the TGP stage 100.

The controller 20 may be configured to individually test the pairs of superconductor-semiconductor junctions 44 for MZM formation when performing the TGP stage 100. The search for the topological region 110 may be performed on the pairs of superconductor-semiconductor junctions 44 until the controller 20 identifies the plunger gate voltage topological values 114 and the magnetic field topological value 116 that result in formation of MZMs 118 at each of the topological superconducting wires 42, or until the controller 20 determines that no such values of the island parameters 102 exist for that Majorana island 12. In instances in which the controller 20 determines that there are no island parameter values for which all the topological superconducting wires 42 form MZMs 118, the controller 20 may be configured to store an indication that the Majorana island 12 is defective.

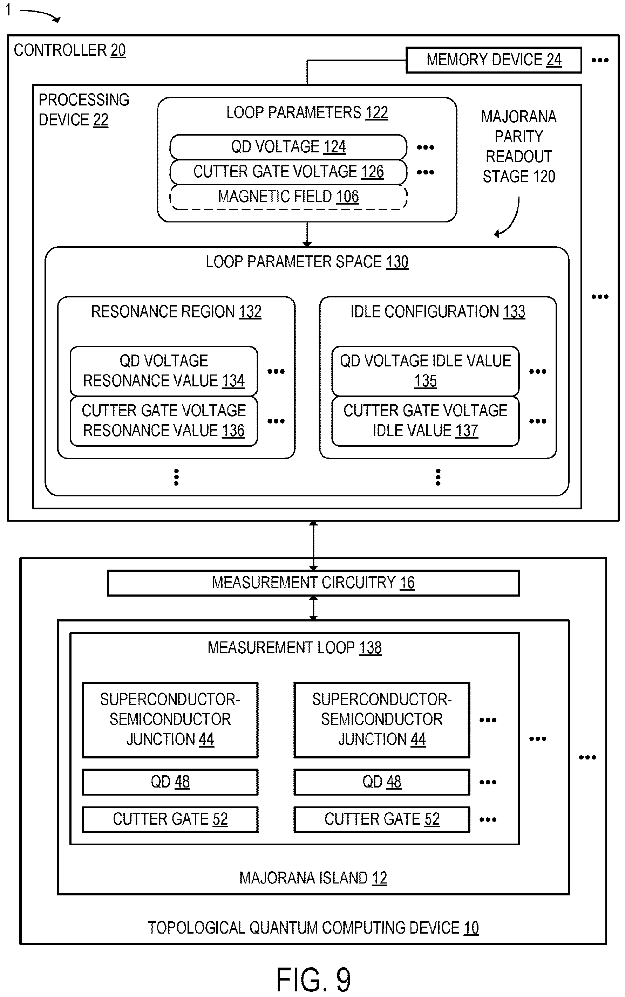

FIG. 9 schematically shows the computing system 1 when the controller 20 is further configured to perform a Majorana parity readout (MPR) stage 120 for each Majorana island 12 subsequently to performing the TGP stage 100. In the MPR stage 120, the controller 20 is further configured to set a plurality of loop parameters 122 for each of a plurality of measurement loops 138 through the Majorana island 12. The measurement loops 138 each include two or more superconductor-semiconductor junctions 44 and one or more QDs 48 included in the Majorana island 12. Each measurement loop 138 may correspond to a respective joint fermionic parity operator. Thus, measurements may be performed at the measurement loops 138 during operation of the topological quantum computing device 10 to perform quantum computations.

For each measurement loop 138, the loop parameters 122 that are set during the MPR stage 120 include a respective plurality of QD voltages 124 applied to respective QDs 48 that are included in the Majorana island 12 and located within the measurement loop 138. In addition, the loop parameters 122 include a respective plurality of cutter gate voltages 126 of the cutter gates 52 included in the Majorana island 12. The QD voltages 124 and the cutter gate voltages 126 associated with the measurement loop 138 form a loop parameter space 130. A magnetic field through the measurement loop 138 may also be included among the loop parameters 122 in some examples. This magnetic field may be the magnetic field 106 that is set as an island parameter 102 in the example of FIG. 8.

During the MPR stage 120, for each measurement loop 138, the controller 20 is configured to search over the loop parameter space 130 to set the loop parameters 122 of that measurement loop 138 to respective values within a resonance region 132. The resonance region 132 is a region of the loop parameter space 130 in which the one or more of QDs 48 included in the measurement loop 138 is resonant with a topological superconducting wire 42 included in the measurement loop 138. In examples in which the measurement loop 138 includes multiple topological superconducting wires 42, each of these topological superconducting wires 42 may be resonant with one or more respective QDs 48 when the loop parameters 122 are within the resonance region 132. In some examples, the resonance region 132 may be a region in which each of the QDs 48 in the measurement loop 138 exhibit resonance, whereas in other examples, a subset of the QDs 48 may exhibit resonance. When the loop parameters 122 are in the resonance region 132, the energy difference between an electron occupying any one of the QDs 48 and the topological superconducting wire 42 may be approximately minimized.

The controller 20 is configured to identify QD voltage resonance values 134 of the QD voltages 124 and cutter gate resonance values 136 of the cutter gate voltages 126 that result in high measurement visibility. In some examples, the controller 20 is configured to search for the QD voltage resonance values 134 and the cutter gate resonance values 136 by performing dispersive gate sensing at the measurement circuitry 16 as the QD voltages and the cutter gate voltages 126 are varied. The values of the loop parameters 122 that result in resonance may be values at which QD-QD coupling strengths and/or QD-MZM coupling strengths are approximately maximized.

By performing the MPR stage 120, the controller 20 is configured to tune the loop parameters 122 of the measurement loops 138 to values in which resonance between the QDs 48 and the superconductor-semiconductor junctions 44 allows for high measurement visibility when joint fermionic parity measurements are performed. During the MPR stage 120, the controller 20 is further configured to select values of the loop parameters 122 at which interferometer arms of the Majorana island 12 are balanced. The interferometer arms of the Majorana island are the components that close the measurement loop 138 between the MZMs and the QD 48 that is undergoing measurement. In some examples, an interferometer arm is formed from a cutter gate 52, whereas in other examples, the interferometer arm includes a plurality of cutter gates 52 and QDs 48. The interferometer arms are balanced when the amplitude of transferring an electron from a measured QD 48 to one of the superconductor-semiconductor junctions 44 included in the measurement loop 138 is approximately equal to the amplitude of transferring the electron to the other superconductor-semiconductor junctions 44 included in the measurement loop 138.

During the MPR stage 120, when the loop parameters 122 are set for a measurement loop 138 that includes a superconductor-semiconductor junction 44 that was already tuned as part of a previously tuned measurement loop 138, the controller 20 may be configured to hold the loop parameters for that superconductor-semiconductor junction 44 at the values obtained during tuning of the previously tuned measurement loop 138. Accordingly, the controller 20 may decrease the duration of the MPR stage 120.

The controller 20 is further configured to identify a respective idle configuration 133 within the loop parameter space 130 for each measurement loop 138 during the MPR stage 120. The idle configuration 133 is a set of values of the loop parameters 122 at which the QDs 48 included in the measurement loop 138 is not resonant with the topological superconducting wire 42 included in that measurement loop 138. In examples in which the measurement loop 138 includes MZMs 118 located in separate topological superconducting wires 42, the QDs 48 included in the measurement loop 138 is not resonant with either of the topological superconducting wires 42 when the loop parameters 122 are in the idle configuration 133. The controller 20 is configured to specify the idle configuration 133 with a plurality of QD voltage idle values 135 and a plurality of cutter gate voltage idle values 137. When identifying the idle configuration 133, the controller 20 is configured to identify voltages at which the QDs 48 included in the measurement loop 138 are coupled to each other while the measurement loop 138 is decoupled from other portions of the Majorana island 12.

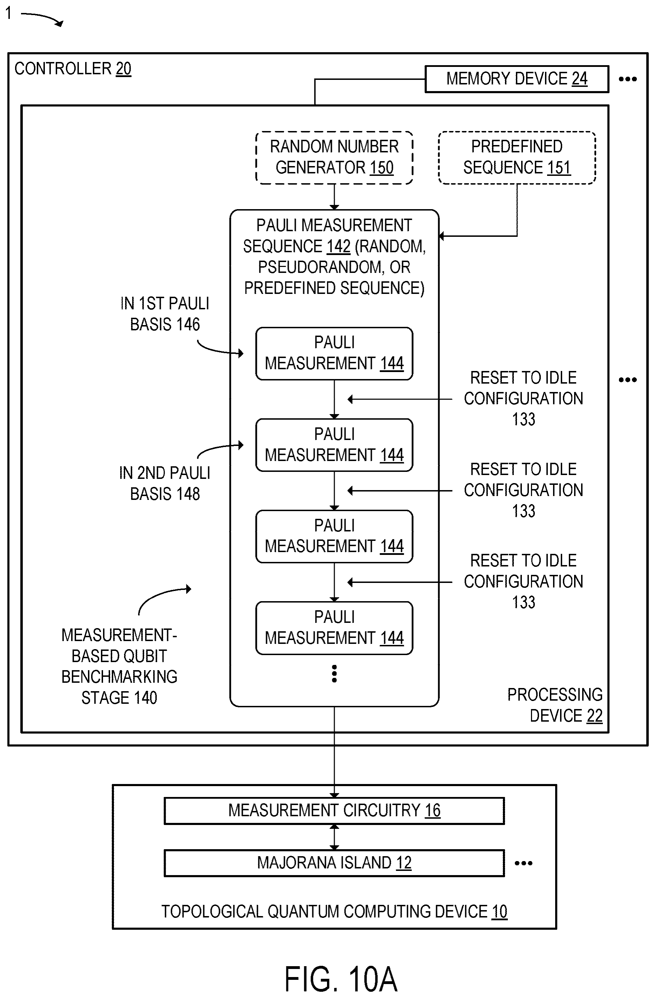

FIGS. 10A-10B schematically show the computing system 1 when the controller 20 is further configured to perform a measurement-based qubit benchmarking (MBQB) stage 140 for each Majorana island 12 subsequently to the MPR stage 120. During the MBQB stage 140, the controller 20 is configured to determine an error metric value 170 of a qubit error metric 164 for the Majorana island 12. The controller 20 is further configured to output the error metric value 170. Thus, the controller 20 is configured to measure the error properties of the Majorana islands 12 subsequently to tuning the island parameters 102 in the TGP stage 100 and tuning the loop parameters 122 in the MPR stage 120.

Performing the MBQB stage 140 for a Majorana island 12 includes performing a Pauli measurement sequence 142 at the Majorana island 12. The Pauli measurement sequence 142 includes a plurality of Pauli measurements 144, which are measurements of Pauli $X, Y,$ or $Z$ operators. In some examples, as shown in FIG. 10A, the controller 20 may be configured to select each of the Pauli measurements 144 to be either a measurement in a first Pauli basis 146 or a second Pauli basis 148. The first Pauli basis 146 and the second Pauli basis 148 are specified as an $X$ basis and a $Z$ basis in the examples provided below. However, another choice of basis defined by a pair of non-commuting Pauli operators may be used in other examples. Two Pauli operators measured at the Majorana island 12 are non-commuting when the measurements of those Pauli operators share exactly one MZM 118. In other examples, Pauli measurements 144 in all three of the Pauli $X, Y,$ and $Z$ bases may be included in the Pauli measurement sequence 142. Pauli measurements in different bases are performed at different measurement loops 138.

In some examples, as shown in FIG. 10A, the Pauli measurements 144 included in the Pauli measurement sequence 142 are each randomly or pseudorandomly selected from between the two non-commuting Pauli measurements 144. For example, a random number generator 150 executed at the controller 20 may be configured to select each of the Pauli measurements 144 as either a Pauli $X$ measurement or a Pauli $Z$ measurement with a probability of 0.5 for each of the Pauli measurement types. In other examples, the Pauli measurement sequence 142 is a predefined sequence 151 including instances of the non-commuting Pauli measurements 144. For example, a predefined sequence 151 may be used when the number of Pauli measurements 144 is small (e.g., below 100), whereas a random or pseudorandom sequence of Pauli measurements 144 may be performed in examples in which the Pauli measurement sequence 142 includes a larger number of Pauli measurements 144.

As shown in FIG. 10A, the controller 20 may be further configured to set the Majorana island 12 to the idle configuration 133 identified during the MPR stage 120 between adjacent Pauli measurements 144 in the Pauli measurement sequence 142. The controller 20 may, for example, be configured to tune the Majorana island 12 between the resonance region 132 and the idle configuration 133 at least in part by pulsing the plunger gate voltages 104 of plunger gates 50 located proximate to the QDs 48. Additionally or alternatively, the controller may be configured to pulse the cutter gate voltages 126 of one or more of the cutter gates 52 to open or close corresponding tunnel junctions through the semiconductor region 40 when tuning the Majorana island between the resonance region 132 and the idle configuration 133. As another approach, the controller 20 may be configured to tune the QDs 48 included in the Majorana island 12 on or off resonance by controlling the voltage on adjacent gates that have a finite lever arm with respect to the QD potential. The term "lever arm" refers here to a proportionality constant between a change in a voltage on a gate and a change in the electrostatic potential of a QD 48.

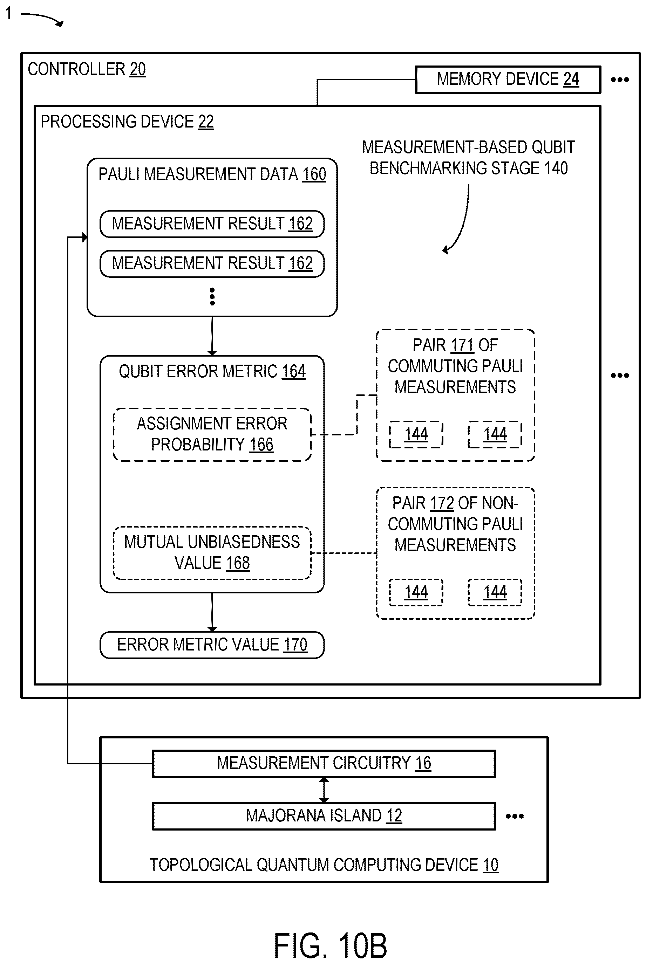

Subsequently to performing the Pauli measurement sequence 142 at the Majorana island 12, the controller 20 is further configured to receive Pauli measurement data 160 including a plurality of Pauli measurement results 162. The MBQB stage 140 further includes computing the error metric value 170 based at least in part on respective results 162 of the plurality of Pauli measurements 144, as shown in the example of FIG. 10B. In an error-free qubit, successive measurements in the same basis have a 100:0 distribution of measurement results 162, whereas successive measurements in anticommuting bases have a 50:50 distribution of measurement results 162. The qubit error metric 164 may measure deviation from the above distributions.

In some examples, the controller 20 may be configured to compute the error metric value 170 at least in part by computing respective assignment error probabilities 166 of the Pauli measurements 144. These assignment error probabilities 166 may be computed for pairs 171 of commuting Pauli measurements 144. For example, the commuting Pauli measurements 144 in the pair 171 may both be Pauli $X$ measurements or may both be Pauli $Z$ measurements. Additionally or alternatively, the controller 20 may be configured to compute the error metric value 170 at least in part by computing respective mutual unbiasedness values 168 of pairs 172 of non-commuting Pauli measurements 144 that are adjacent in the Pauli measurement sequence 142. The computation of the assignment error probabilities 166 and the mutual unbiasedness values 168 is discussed below.

In examples in which the controller 20 is configured to compute assignment error probabilities 166 of the Pauli measurements 144, each assignment error probability 166 is the probability of a specific Pauli measurement 144 returning an incorrect value. The Pauli $Z$ measurement outcomes are labeled as $\{+Z, -Z\}$ in the following discussion, and the Pauli $X$ measurement outcomes are labeled as $\{+X, -X\}$. In addition, $p(a|b)$ indicates the probability of measuring an outcome $a$ conditional on measuring a previous outcome of $b$. $p(aZ|X)$ indicates the probability of a $Z$ measurement returning the outcome $a$ conditional on the previous measurement having been an $X$ measurement, regardless of the outcome of that $X$ measurement. Similarly, $p(aX|Z)$ indicates the probability of an $X$ measurement returning an outcome of $a$ conditional on the previous measurement having been a *Z* measurement, regardless of the outcome of that *Z* measurement.

Given the above measurement outcome and probability definitions, the assignment error probability 166 of a Pauli measurement 144 may be computed as follows:

$$P_A^Z = \max[1 - p(+Z| + Z), 1 - p(-Z| - Z)]$$

$$P_A^X = \max[1 - p(+X|+X), 1 - p(-X|-X)]$$

The assignment error probability 166 tests the error rates of the Pauli measurements 144 separately from each other. An assignment error probability of 0 indicates perfect accuracy, and an assignment error probability of 0.5 indicates equal probabilities of correct and incorrect outcomes.

The mutual unbiasedness values 168 measure the extent to which pairs 172 of Pauli measurements 144 anticommute with each other. A mutual unbiasedness value of 0 indicates perfect anticommutation, whereas a mutual unbiasedness value of 0.5 indicates perfect commutation. In examples in which the qubit error metric 164 is a mutual unbiasedness value 168, the controller 20 may be configured to compute the mutual unbiasedness values 168 as follows:

$$P_M^{XZ} = \max[p(+X|Z) - 0.5, p(-X|Z) - 0.5]$$

$$P_M^{ZX} = \max[p(+Z|X) - 0.5, p(-Z|X) - 0.5]$$

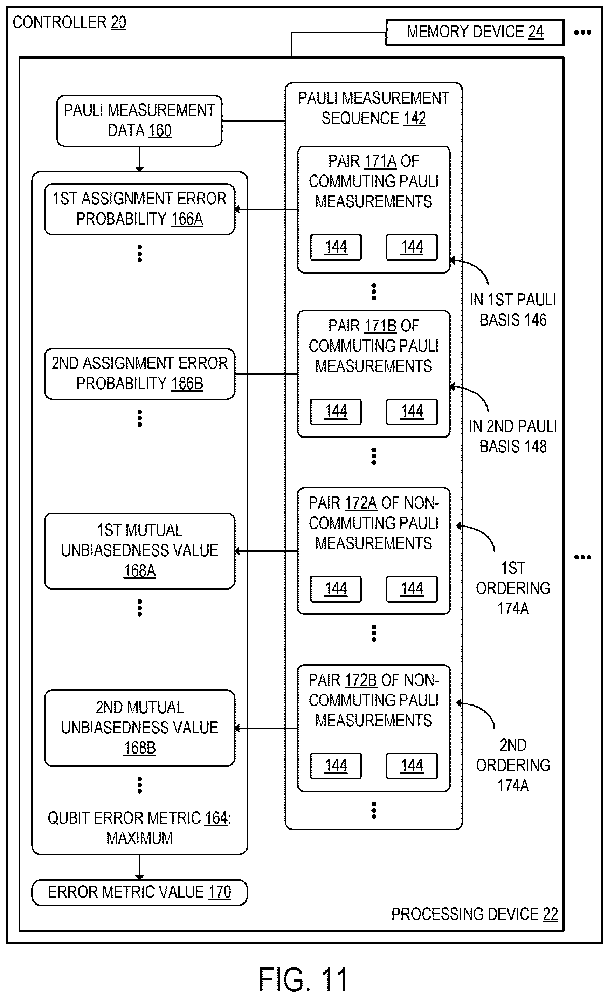

In some examples, as shown in FIG. 11, the controller 20 may be configured to compute both assignment error probabilities 166 and mutual unbiasedness values 168 when computing the error metric value 170. In the example of FIG. 11, the controller 20 is configured to compute the error metric value 170 as a maximum of one or more first assignment error probabilities 166A computed in a first Pauli basis 146, one or more second assignment error probabilities 166B computed in a second Pauli basis 148, one or more first mutual unbiasedness values 168A computed for a first ordering 174A of non-commuting Pauli measurements, and one or more second mutual unbiasedness values 168B computed for a second ordering 174B of the non-commuting Pauli measurements 144. For example, the first ordering 174A and the second ordering 174B may be *XZ* and *ZX,* respectively. In such an example, the error metric value 170 may be computed as:

$$P_{err} = \max[P_A^Z, P_A^X, P_M^{XZ}, P_M^{ZX}]$$

Thus, the error metric value 170 in the example of FIG. 11 encodes information related to error rates in pairs 172 of adjacent non-commuting Pauli measurements 144 as well as in the individual Pauli measurements 144.

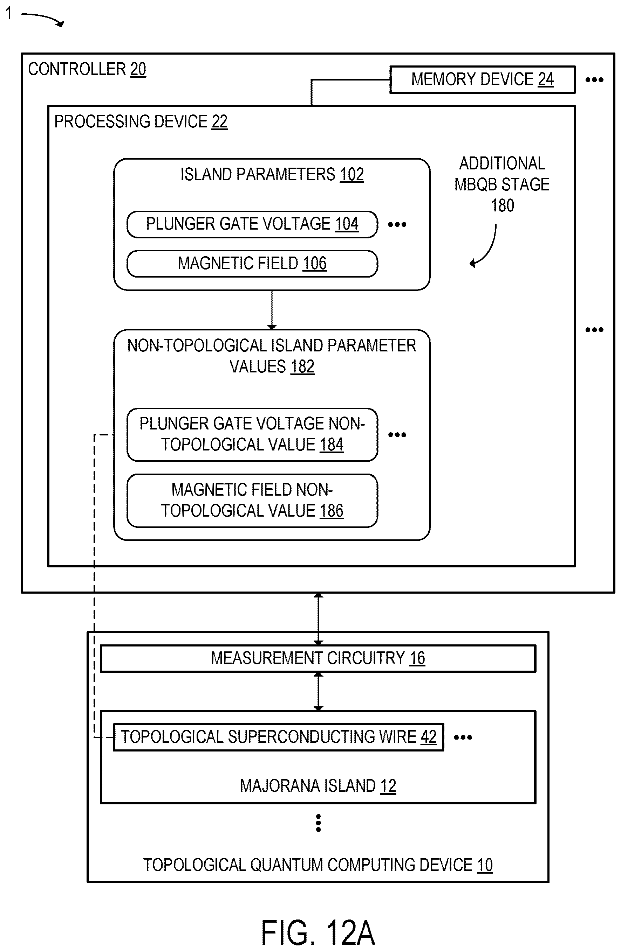

FIGS. 12A-12B schematically show the computing system 1 in an example in which the controller 20 is further configured to compute a false positive rate 192 of the error metric value 170. In FIG. 12A, the computing system 1 is shown when the controller 20 is further configured to perform an additional MBQB stage 180 for values of the island parameters 102 that are outside the topological region 110. The controller 20 may be configured to perform the additional MBQB stage 180 for each of the one or more topological superconducting wires 42 included in the Majorana island 12.

During the additional MBQB stage 180, the controller 20 is configured to set the island parameters 102 to non-topological island parameter values 182, which may include a plurality of plunger gate voltage non-topological values 184 and a magnetic field non-topological value 186. In some examples, one or more of the plunger gate voltage non-topological values 184 and/or the magnetic field non-topological value 186 may be equal to the topological values while respective values of one or more other island parameters 102 are outside the topological region 110. When a topological superconducting wire 42 operates outside the topological region 110, as shown in FIG. 12A, that topological superconducting wire 42 does not exhibit topological superconductivity.

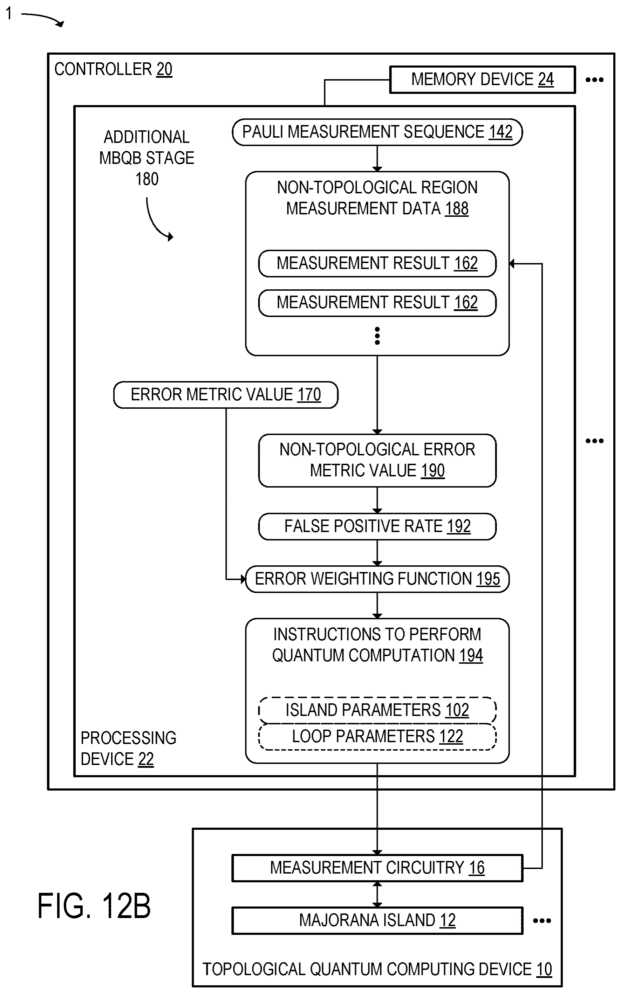

As shown in FIG. 12B, the controller 20 is further configured to perform the Pauli measurement sequence 142 while the Majorana island 12 is outside the topological region 110. Thus, the controller 20 is configured to obtain non-topological region measurement data 188 including a plurality of measurement results 162. The same Pauli measurement sequence 142 used in the MBQB stage 140 is used in the additional MBQB stage 180. The controller 20 is further configured to compute a non-topological error metric value 190 based at least in part on the measurement results 162 included in the non-topological region measurement data 188. The non-topological error metric value 190 may be computed using the approaches discussed above with reference to FIGS. 10A-11.

Based at least in part on the error metric value 170 and the non-topological error metric value 190, the controller 20 is further configured to compute a false positive rate 192 of the error metric value 170.

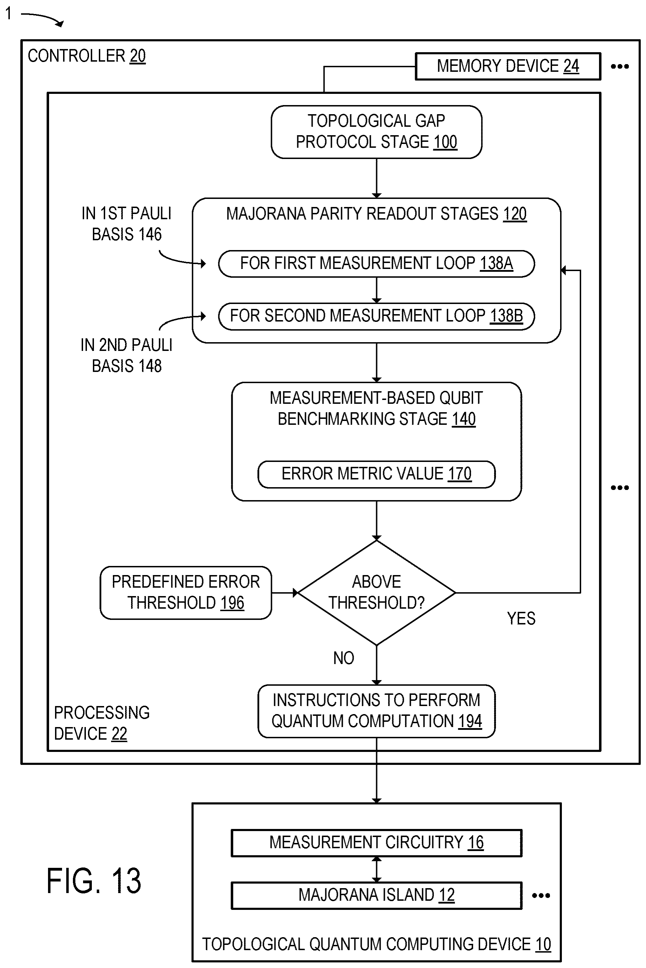

Based at least in part on the error metric value 170 and the false positive rate 192, the controller 20 is further configured to select respective values of one or more of the island parameters 102 and/or the loop parameters 122 for use in a quantum computation 194 performed at the topological quantum computing device 10. The controller 20 may, for example, be configured to select the island parameters 102 and/or the loop parameters 122 as values that approximately maximize or minimize an error weighting function 195. Thus, the controller 20 is configured to balance a tradeoff between the false positive rate 192 and an overall error rate. When the controller 20 transmits, to the topological quantum computing device 10, instructions to perform a quantum computation 194, the controller 20 may be configured to specify the selected values of the island parameters 102 and/or the loop parameters 122 in those instructions. FIG. 13 schematically shows the computing system 1 when the TGP stage 100, the MPR stage 120, and the MBQB stage 140 are performed. In the example of FIG. 13, the controller 20 is configured to perform the MPR stage 120 for a respective first measurement loop 138A and second measurement loop 138B corresponding to measurements in the first Pauli basis 146 and the second Pauli basis 148. The controller 20 is accordingly configured to identify respective resonance regions 132 and idle configurations 133 for measurements in the first Pauli basis 146 and the second Pauli basis 148 prior to performing those measurements during the MBQB stage 140.

In some examples, as shown in FIG. 13, the controller 20 may be further configured to determine that the error metric value 170 computed during the MBQB stage 140 is above a predefined error threshold 196. In response to determining that the error metric value 170 is above the predefined error threshold 196, the controller 20 may be further configured to repeat the MPR stage 120 and the MBQB stage 140. In some examples, such as those in which the controller 20 determines that the assignment error probability 166 is above the predefined error threshold 196 in one of the first Pauli basis 146 and the second Pauli basis 148 but not the other, the controller 20 may be configured to repeat the MPR stage 120 for the first measurement loop 138A or the second measurement loop 138B without repeating the other. Alternatively, such as in examples in which a mutual unbiasedness value 168 is above the predefined error threshold 196, the controller 20 may be further configured to repeat both MPR stages 120A and 120B. When the controller 20 determines that the error metric value 170 is below the predefined error threshold 196, the controller 20 may be further configured to generate the instructions to perform the quantum computation 194 as discussed above.

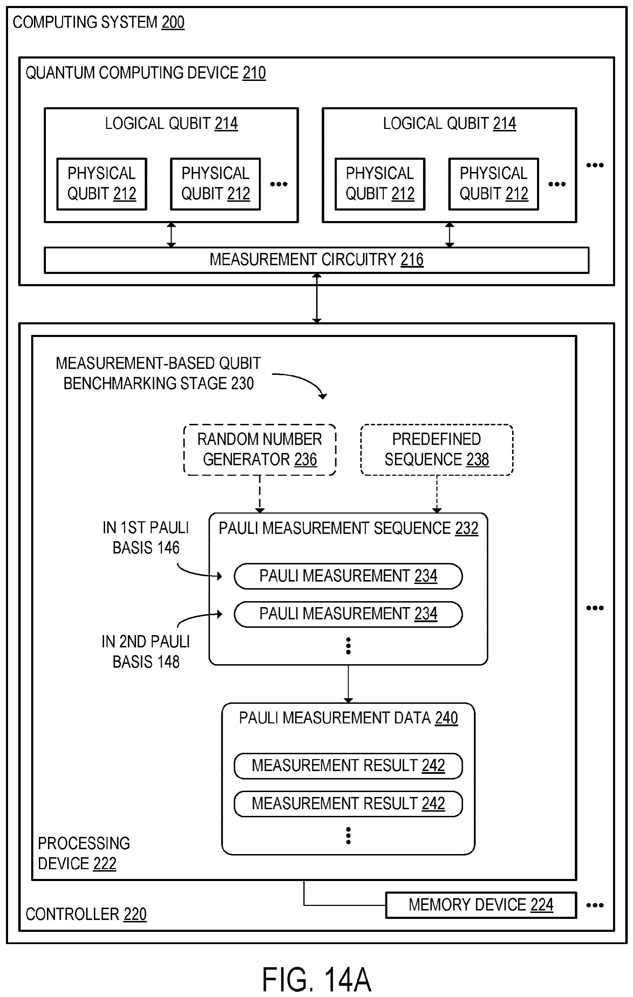

Although the above discussion refers to performing the MBQB stage 140 at a topological quantum computing device 10 to benchmark physical qubits, an MBQB stage may also be performed to benchmark logical qubits. This logical qubit benchmarking may be performed at a quantum computing device using any quantum computing architecture rather than being limited to topological quantum computing devices. FIGS. 14A-14B schematically shows an example computing system 200, including a quantum computing device 210 and a controller 220, when an MBQB stage 230 is performed on logical qubits 214. The quantum computing device 210 includes a plurality of sets of physical qubits 212 that form respective logical qubits 214. In addition, the quantum computing device 210 includes measurement circuitry 216 that is configured to measure observables of the physical qubits 212. The quantum computing device 210 may be a topological quantum computing device in some examples, whereas in other examples, the quantum computing device 210 may utilize some other quantum computing architecture. For example, the quantum computing device 210 shown in FIGS. 14A-14B may utilize superconducting qubits, QD qubits, trapped-ion qubits, neutral-atom qubits, or photonic qubits, to name several non-limiting examples.

The controller 220 depicted in the example of FIG. 14A-14B is a classical computing device that includes one or more processing devices 222 and one or more memory devices 224. The controller 220 is configured to receive measurement results 242 from the quantum computing device 210. The controller 220 is further configured to generate control instructions 254 that are executed to control the quantum computing device 210.

During the MBQB stage 230, the controller 220 is configured to control the quantum computing device 210 to perform a Pauli measurement sequence 232 including a plurality of Pauli measurements 234. These Pauli measurements 234 are measurements of respective Pauli operators that are performed at the logical qubits 214. In some examples, the Pauli measurements 234 included in the Pauli measurement sequence 232 are each randomly or pseudorandomly selected at a random number generator 236 from between two non-commuting Pauli measurements 234. The two non-commuting Pauli measurements 234, in such examples, are respectively performed in a first Pauli basis 146 and a second Pauli basis 148. The Pauli measurement sequence 232 may alternatively be a predefined sequence 238 of instances of non-commuting Pauli measurements 234.

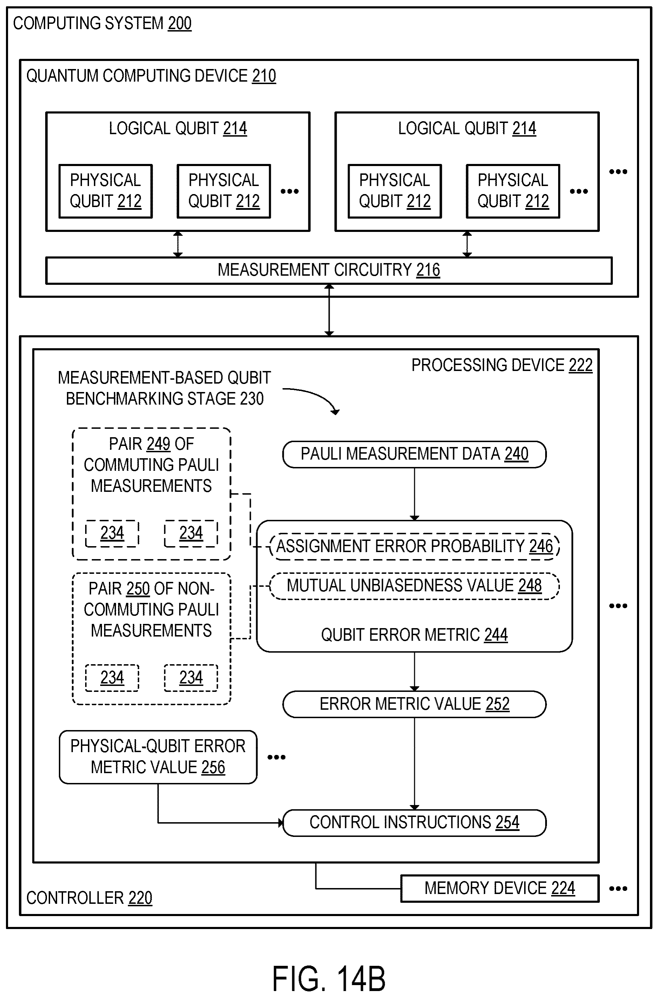

As shown in the example of FIG. 14B, the controller 220 is further configured to determine an error metric value 252 of a qubit error metric 244 during the MBQB stage 230 based at least in part on respective results 242 of the plurality of Pauli measurements 234. The error metric value 252 is associated with a logical qubit 214 of the plurality of logical qubits 214. In some examples, as depicted in FIG. 14B, the controller 220 may be configured to compute the error metric value 252 at least in part by computing respective assignment error probabilities 246 of pairs 249 of commuting Pauli measurements 234 that are adjacent in the Pauli measurement sequence 232. Additionally or alternatively, the controller 220 may be configured to compute the error metric value 252 at least in part by computing respective mutual unbiasedness values 248 of pairs 250 of non-commuting Pauli measurements 234 that are adjacent in the Pauli measurement sequence 232.

The controller 220 is further configured to generate control instructions 254 to control the physical qubits 212 included in the logical qubit 214 based at least in part on the error metric value 252. The control instructions 254 may be instructions to set parameters of the physical qubits 212, such as one or more voltages or magnetic field values.

In some examples in which the physical qubits 212 are measurement-based qubits, as in the topological quantum computing device 10 discussed above, the controller 220 may be further configured to determine respective physical-qubit error metric values 256 of the physical qubits 212 included in the logical qubit 214. The physical-qubit error metric values 256 may be the error metric values 170 discussed above with reference to FIGS. 10A-10B. In examples in which the controller 220 obtains physical-qubit error metric values 256, the controller 220 may be further configured to control the physical qubits 212 based at least in part on the physical-qubit error metric values 256, as well as on the error metric value 252 of the logical qubit 214. For example, the controller 220 may be configured to exclude, from a subsequent quantum computation, one or more physical qubits 212 that have high physical-qubit error metric values 256 and are included in logical qubits 214 that have high error metric values 252.

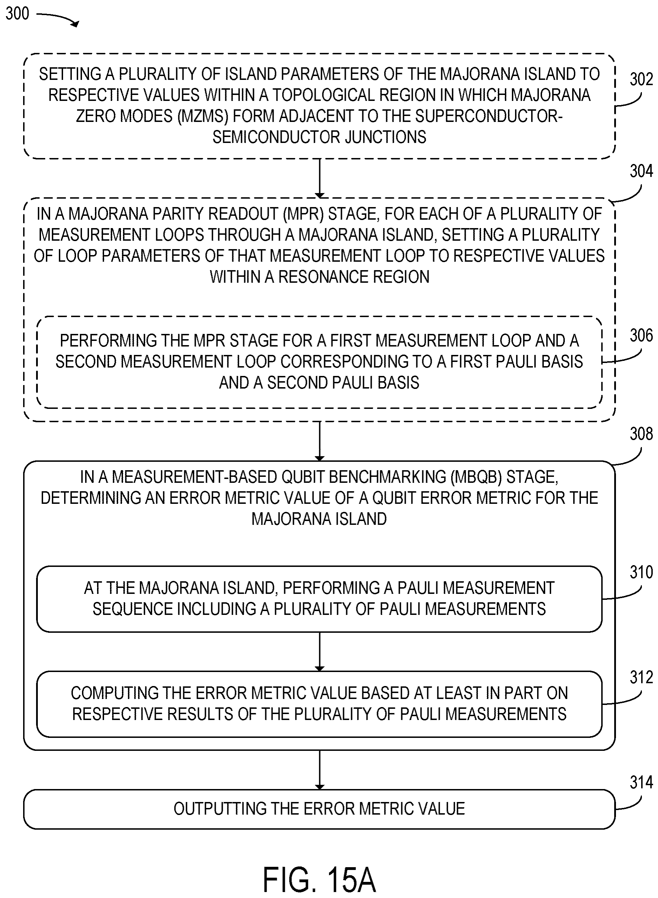

FIG. 15A schematically shows a flowchart of a method 300 for use with a computing system that includes a topological quantum computing device and a controller. The topological quantum computing device includes a plurality of Majorana islands that form a plurality of physical qubits. Each of the Majorana islands may include a plurality of superconductor-semiconductor junctions at which respective MZMs are instantiated. In addition, the Majorana islands may each include one or more semiconductor regions, one or more QDs included in the one or more semiconductor regions, one or more trivial superconductors, a plurality of plunger gates, and a plurality of cutter gates. In some examples, at step 302, the method 300 includes performing a TGP stage. The TGP stage includes setting a plurality of island parameters of the Majorana island to respective values within a topological region in which MZMs form adjacent to the superconductor-semiconductor junctions. The island parameters may include plunger gate voltages of the plunger gates. The island parameters may further include a magnetic field applied to the Majorana island.

At step 304, the method 300 further includes performing an MPR stage. In the MPR stage, for each of a plurality of measurement loops through the Majorana island, the method 300 further includes setting a plurality of loop parameters of that measurement loop to respective values within a resonance region. The loop parameters may, for example, include QD voltages of the QDs, and may further include cutter gate voltages of the cutter gates. The resonance region is a region of a loop parameter space in which one or more of the QDs included in the measurement loop are resonant with a topological superconducting wire included in the measurement loop. In some examples, at step 306, step 304 may include performing the MPR stage for a first measurement loop and a second measurement loop a first Pauli basis and a second Pauli basis. In such examples, resonance regions corresponding to the first and second Pauli bases may be identified at step 304.

At step 308, the method 300 further includes performing an MBQB stage. For example, the MBQB stage may be performed subsequently to the MPR stage as part of a bring-up procedure for the topological quantum computing device. The MBQB stage includes determining an error metric value of a qubit error metric for the Majorana island. Performing the MBQB stage at step 308 includes, at step 310, performing a Pauli measurement sequence including a plurality of Pauli measurements at the Majorana island. At step 312, performing the MBQB stage further includes computing the error metric value based at least in part on respective results of the plurality of Pauli measurements included in the Pauli measurement sequence.

At step 314, the method 300 further includes outputting the error metric value. Thus, by performing the method 300, the computing system characterizes the error properties of the Majorana island. In some examples, the error metric value is further utilized to generate control instructions for the topological quantum computing device.

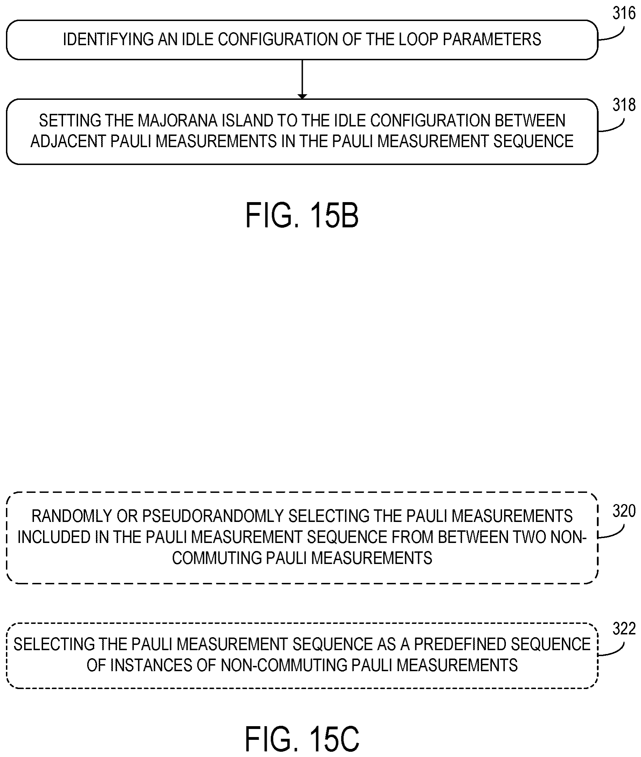

FIGS. 15B-15F show additional steps of the method 300 of FIG. 15A that may be performed in some examples. FIG. 15B shows additional steps that may be performed during the MPR stage at step 304. At step 316, performing the MPR stage may further include identifying an idle configuration of the loop parameters. The idle configuration is a set of loop parameters at which resonance does not occur between the QDs and the one or more topological superconducting wires that are included in the measurement loop. For example, identifying the idle configuration may include identifying voltages at which the QDs included in the Majorana island are coupled to each other when the Majorana island is decoupled from other regions of the Majorana island. At step 318, in examples in which step 316 is performed, the method 300 may further include setting the Majorana island to the idle configuration between adjacent Pauli measurements in the Pauli measurement sequence.

FIG. 15C shows additional steps that may be performed to generate the Pauli measurement sequence. At step 320, the method 300 may further include randomly or pseudorandomly selecting the Pauli measurements included in the Pauli measurement sequence from between two non-commuting Pauli measurements. Alternatively, at step 322, the method 300 may further include selecting the Pauli measurement sequence as a predefined sequence of instances of non-commuting Pauli measurements. In other examples, Pauli measurements from three different Pauli bases may be included in the Pauli measurement sequence.

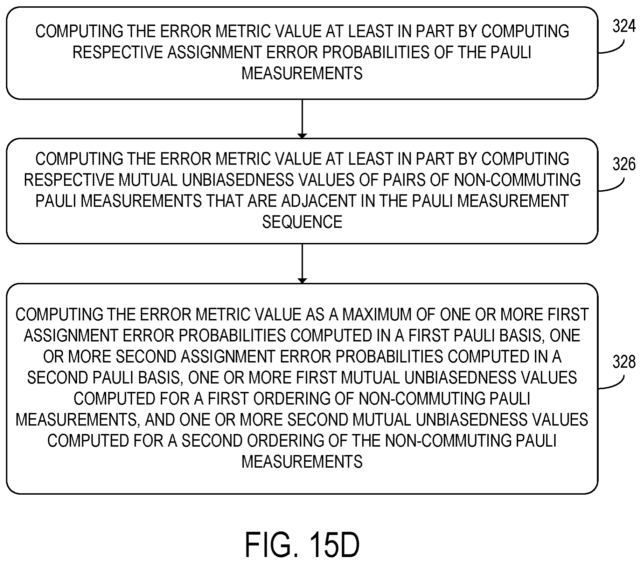

FIG. 15D shows additional steps that may be performed to compute the error metric value at step 312. At step 324, step 312 may include computing respective assignment error probabilities of the Pauli measurements. The assignment error probabilities may be computed for pairs of commuting Pauli measurements that are adjacent to each other in the Pauli measurement sequence. Additionally or alternatively, at step 326, step 312 may include computing respective mutual unbiasedness values of pairs of non-commuting Pauli measurements that are adjacent in the Pauli measurement sequence. In examples in which both steps 324 and 326 are performed, step 312 may further include, at step 328, computing the error metric value as a maximum of one or more first assignment error probabilities computed in a first Pauli basis, one or more second assignment error probabilities computed in a second Pauli basis, one or more first mutual unbiasedness values computed for a first ordering of non-commuting Pauli measurements, and one or more second mutual unbiasedness values computed for a second ordering of the non-commuting Pauli measurements.

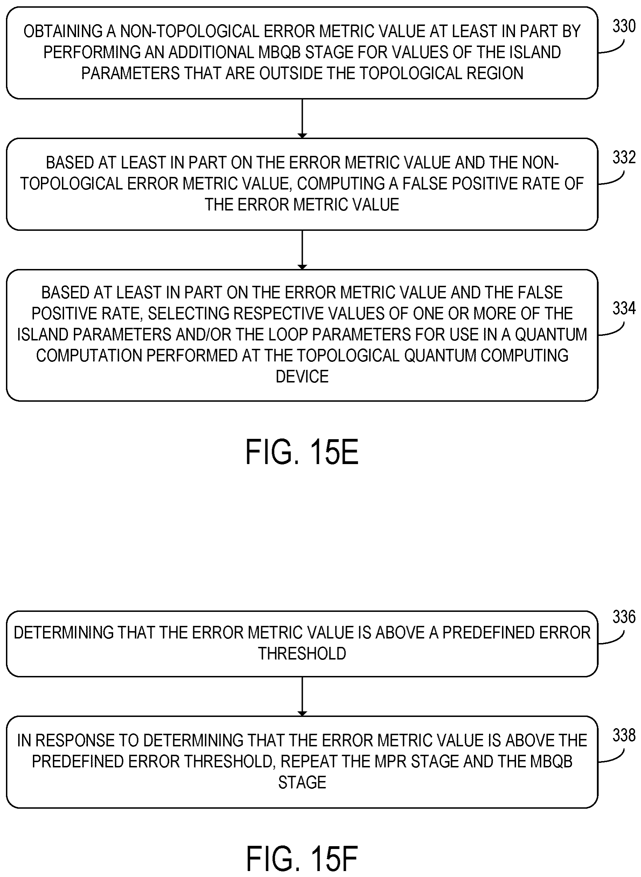

FIG. 15E shows additional steps of the method 300 that may be performed in some examples. At step 330, the method 300 may further include obtaining a non-topological error metric value. The non-topological error metric value may be obtained by performing an additional MBQB stage for values of the island parameters that are outside the topological region. The non-topological region of the island parameter space may be identified during the TGP stage.

At step 332, the method 300 may further include computing a false positive rate of the error metric value based at least in part on the error metric value and the non-topological error metric value. At step 334, the method 300 may further include selecting respective values of one or more of the island parameters and/or the loop parameters based at least in part on the error metric value and the false positive rate. Those values of the island parameters and/or the loop parameters are selected for use in a quantum computation performed at the topological quantum computing device. For example, performing step 334 may include computing a value of an error weighting function based at least in part on the error metric value and the false positive rate.

FIG. 15F shows additional steps of the method 300 that may be performed in some examples. At step 336, the method 300 may further include determining that the error metric value is above a predefined error threshold. At step 338, the method 300 may further include repeating the MPR stage and the MBQB stage in response to determining that the error metric value is above the predefined error threshold. For example, the steps of FIG. 15F may be used to correct an inaccurate identification of the resonance region made during the MPR stage.

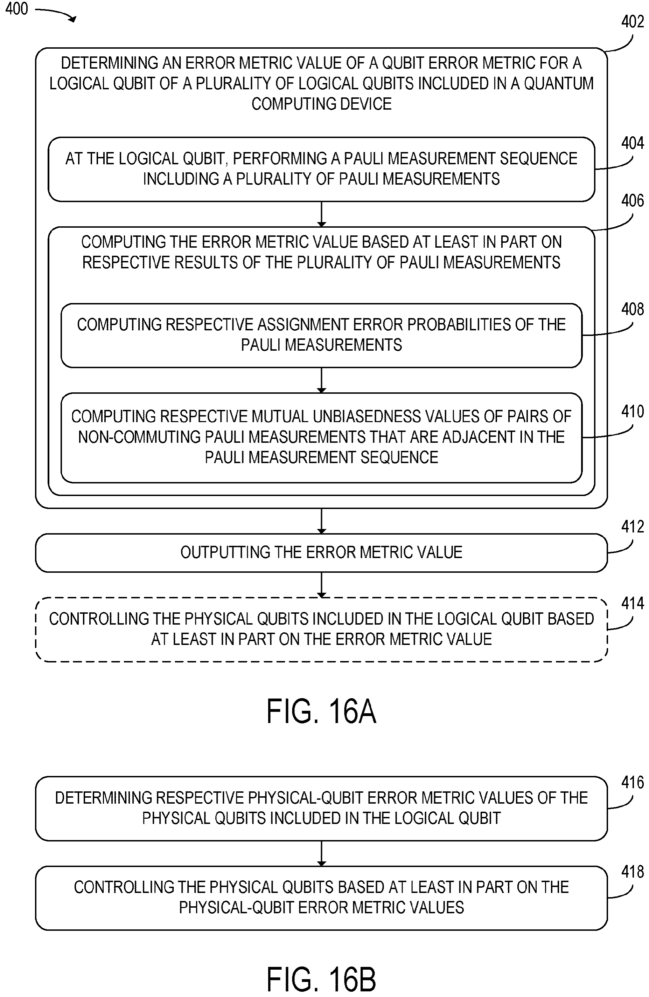

FIG. 16A shows a flowchart of a method 400 for use with a computing system to benchmark the error properties of logical qubits included in a quantum computing device. At step 402, the method 400 may include determining an error metric value of a qubit error metric for a logical qubit. Step 402 includes, at step 404, performing a Pauli measurement sequence at the logical qubit. The Pauli measurement sequence may be a predefined sequence or may be randomly or pseudorandomly generated. Each of the Pauli measurements in the Pauli measurement sequence may be selected from a pair of non-commuting Pauli bases.

At step 406, step 402 further includes computing the error metric value based at least in part on respective results of the plurality of Pauli measurements. Computing the error metric value at step 406 may include, at step 408, computing respective assignment error probabilities of the Pauli measurements. Additionally or alternatively, step 406 may include, at step 410, computing respective mutual unbiasedness values of pairs of non-commuting Pauli measurements. Those pairs of non-commuting Pauli measurements are adjacent in the Pauli measurement sequence. At step 412, the method 400 further includes outputting the error metric value. In some examples, the method 400 further includes, at step 414, controlling the physical qubits included in the logical qubit based at least in part on the error metric value. Thus, the controller may adapt the control sequences for the physical qubits based on the extracted error metric value. For example, step 414 may include recalibrating the physical qubits included in a logical qubit that has a high error metric value. As another example, the controller may exclude that logical qubit from use in a subsequent computation.

FIG. 16B shows additional steps of the method 400 of FIG. 16A that may be performed in examples in which the physical qubits that form the logical qubits are measurement-based qubits. At step 416, the method 400 may further include determining respective physical-qubit error metric values of the physical qubits included in the logical qubit. The physical-qubit error metric values may, for example, be determined using the method 300 of FIG. 15A. At step 418, the method 400 may further include controlling the physical qubits based at least in part on the physical-qubit error metric values. For example, physical qubits with high error rates may be recalibrated or excluded from use in quantum computations.

Using the devices and methods discussed above, a controller is configured to perform a measurement-based qubit benchmarking stage to determine the error properties of physical qubits in a topological quantum computing device. These error properties may be determined as part of a bring-up procedure for the topological quantum computing device or may be performed intermittently over the course of device operation. An MBQB stage may also be performed to determine the error properties of logical qubits.

The methods and processes described herein are tied to a computing system of one or more computing devices. In particular, such methods and processes can be implemented as a computer-application program or service, an application-programming interface (API), a library, and/or other computer-program product.

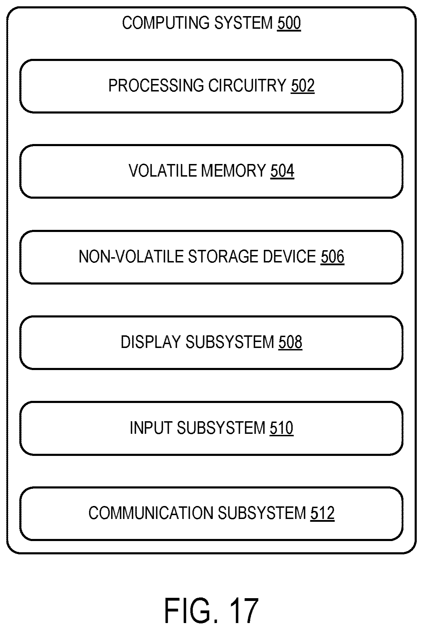

FIG. 17 schematically shows a non-limiting embodiment of a computing system 500 that can enact one or more of the methods and processes described above. Computing system 500 is shown in simplified form and may embody the computing system 1 described above and illustrated in FIG. 1 or the computing system 200 described above and illustrated in FIGS. 14A-14B. Components of computing system 500 may be included in one or more personal computers, server computers, tablet computers, home-entertainment computers, network computing devices, video game devices, mobile computing devices, mobile communication devices (e.g., smartphone), and/or other computing devices, and wearable computing devices such as smart wristwatches and head mounted augmented reality devices.

Computing system 500 includes processing circuitry 502, volatile memory 504, and a non-volatile storage device 506. Computing system 500 may optionally include a display subsystem 508, input subsystem 510, communication subsystem 512, and/or other components not shown in FIG. 17.

Processing circuitry 502 typically includes one or more logic processors, which are physical devices configured to execute instructions. For example, the logic processors may be configured to execute instructions that are part of one or more applications, programs, routines, libraries, objects, components, data structures, or other logical constructs. Such instructions may be implemented to perform a task, implement a data type, transform the state of one or more components, achieve a technical effect, or otherwise arrive at a desired result.

The logic processor may include one or more physical processors configured to execute software instructions. Additionally or alternatively, the logic processor may include one or more hardware logic circuits or firmware devices configured to execute hardware-implemented logic or firmware instructions. Processors of the processing circuitry 502 may be single-core or multi-core, and the instructions executed thereon may be configured for sequential, parallel, and/or distributed processing. Individual components of the processing circuitry 502 optionally may be distributed among two or more separate devices, which may be remotely located and/or configured for coordinated processing. For example, aspects of the computing system disclosed herein may be virtualized and executed by remotely accessible, networked computing devices configured in a cloud-computing configuration. In such a case, these virtualized aspects are run on different physical logic processors of various different machines, it will be understood. These different physical logic processors of the different machines will be understood to be collectively encompassed by processing circuitry 502.

Non-volatile storage device 506 includes one or more physical devices configured to hold instructions executable by the processing circuitry to implement the methods and processes described herein. When such methods and processes are implemented, the state of non-volatile storage device 506 may be transformed-e.g., to hold different data.

Non-volatile storage device 506 may include physical devices that are removable and/or built in. Non-volatile storage device 506 may include optical memory, semiconductor memory, and/or magnetic memory, or other mass storage device technology. Non-volatile storage device 506 may include nonvolatile, dynamic, static, read/write, read-only, sequential-access, location-addressable, file-addressable, and/or content-addressable devices. It will be appreciated that non-volatile storage device 506 is configured to hold instructions even when power is cut to the non-volatile storage device 506.

Volatile memory 504 may include physical devices that include random access memory. Volatile memory 504 is typically utilized by processing circuitry 502 to temporarily store information during processing of software instructions. It will be appreciated that volatile memory 504 typically does not continue to store instructions when power is cut to the volatile memory 504.

Aspects of processing circuitry 502, volatile memory 504, and non-volatile storage device 506 may be integrated together into one or more hardware-logic components. Such hardware-logic components may include field-programmable gate arrays (FPGAs), program- and application-specific integrated circuits (PASIC / ASICs), program- and application-specific standard products (PSSP / ASSPs), system-on-a-chip (SOC), and complex programmable logic devices (CPLDs), for example.

The terms "module," "program," and "engine" may be used to describe an aspect of computing system 500 typically implemented in software by a processor to perform a particular function using portions of volatile memory, which function involves transformative processing that specially configures the processor to perform the function. Thus, a module, program, or engine may be instantiated via processing circuitry 502 executing instructions held by non-volatile storage device 506, using portions of volatile memory 504. It will be understood that different modules, programs, and/or engines may be instantiated from the same application, service, code block, object, library, routine, API, function, etc. Likewise, the same module, program, and/or engine may be instantiated by different applications, services, code blocks, objects, routines, APIs, functions, etc. The terms "module," "program," and "engine" may encompass individual or groups of executable files, data files, libraries, drivers, scripts, database records, etc.

When included, display subsystem 508 may be used to present a visual representation of data held by non-volatile storage device 506. The visual representation may take the form of a graphical user interface (GUI). As the herein described methods and processes change the data held by the non-volatile storage device, and thus transform the state of the non-volatile storage device, the state of display subsystem 508 may likewise be transformed to visually represent changes in the underlying data. Display subsystem 508 may include one or more display devices utilizing virtually any type of technology. Such display devices may be combined with processing circuitry 502, volatile memory 504, and/or non-volatile storage device 506 in a shared enclosure, or such display devices may be peripheral display devices.

When included, input subsystem 510 may comprise or interface with one or more user-input devices such as a keyboard, mouse, touch screen, camera, or microphone.

When included, communication subsystem 512 may be configured to communicatively couple various computing devices described herein with each other, and with other devices. Communication subsystem 512 may include wired and/or wireless communication devices compatible with one or more different communication protocols. As non-limiting examples, the communication subsystem may be configured for communication via a wired or wireless local- or wide-area network, broadband cellular network, etc. In some embodiments, the communication subsystem may allow computing system 500 to send and/or receive messages to and/or from other devices via a network such as the Internet.

"And/or" as used herein is defined as the inclusive or v, as specified by the following truth table:

| A | B | A v B |
|---|---|---|
| True | True | True |
| True | False | True |
| False | True | True |
| False | False | False |

The following paragraphs discuss several aspects of the present disclosure. According to one aspect of the present disclosure, a computing system is provided, including a topological quantum computing device. The topological quantum computing device includes a plurality of Majorana islands that form a plurality of physical qubits. The computing system further includes a controller configured to, for each of the physical qubits, in a measurement-based qubit benchmarking (MBQB) stage, determine an error metric value of a qubit error metric associated with the physical qubit. Determining the error metric value includes, at the Majorana island that forms the physical qubit, performing a Pauli measurement sequence including a plurality of Pauli measurements. Determining the error metric value further includes computing the error metric value based at least in part on respective results of the plurality of Pauli measurements. For each of the physical qubits, the controller is further configured to output the error metric value. The above features may have the technical effect of determining the error properties of the physical qubits.

According to this aspect, in a Majorana parity readout (MPR) stage performed prior to the MBQB stage, for each of the physical qubits, and for each of a plurality of measurement loops through the Majorana island, the controller may be further configured to set a plurality of loop parameters of that measurement loop to respective values within a resonance region. The above features may have the technical effect of achieving high measurement visibility for the Pauli measurements.

According to this aspect, each of the Majorana islands may include a plurality of superconductor-semiconductor junctions. The controller may be further configured to, in a topological gap protocol (TGP) stage performed prior to the MPR stage, set a plurality of island parameters of the Majorana island to respective values within a topological region in which Majorana zero modes (MZMs) form adjacent to the superconductor-semiconductor junctions. The above features may have the technical effect of obtaining MZMs that are usable as the physical qubits.

According to this aspect, for each of the one or more topological superconducting wires, the controller may be further configured to obtain a non-topological error metric value at least in part by performing an additional MBQB stage for values of the island parameters that are outside the topological region. The controller may be further configured to compute a false positive rate of the error metric value based at least in part on the error metric value and the non-topological error metric value. Based at least in part on the error metric value and the false positive rate, the controller may be further configured to select respective values of one or more of the island parameters and/or the loop parameters for use in a quantum computation performed at the topological quantum computing device. The above features may have the technical effect of balancing false positive rates and false negative rates of measurements performed using the physical qubits.

According to this aspect, the controller may be further configured to determine that the error metric value is above a predefined error threshold. In response to determining that the error metric value is above the predefined error threshold, the controller may be further configured to repeat the MPR stage and the MBQB stage. The above features may have the technical effect of recalibrating the measurement loops in response to detecting a high error rate.

According to this aspect, the resonance region may be a region of a loop parameter space defined by a respective plurality of quantum dot (QD) voltages applied to respective QDs included in the Majorana island within the measurement loop. The resonance region may be further defined by a respective plurality of cutter gate voltages of cutter gates included in the Majorana island. In the resonance region, one or more of the QDs included in the measurement loop may be resonant with a topological superconducting wire included in the measurement loop. The above features may have the technical effect of defining the parameters of the measurement loop that are modified when identifying the resonance region.

According to this aspect, the Pauli measurements included in the Pauli measurement sequence may each be randomly or pseudorandomly selected from between two non-commuting Pauli measurements. The above features may have the technical effect of selecting the sequence of Pauli measurements with which the error metric value is determined.

According to this aspect, the Pauli measurement sequence may be a predefined sequence of instances of non-commuting Pauli measurements. The above features may have the technical effect of selecting the sequence of Pauli measurements with which the error metric value is determined.

According to this aspect, the controller may be configured to compute the error metric value at least in part by computing respective assignment error probabilities of the Pauli measurements. The above features may have the technical effect of determining the probabilities of Pauli measurements returning incorrect values.

According to this aspect, the controller may be configured to compute the error metric value at least in part by computing respective mutual unbiasedness values of pairs of non-commuting Pauli measurements that are adjacent in the Pauli measurement sequence. The above features may have the technical effect of measuring the extent to which pairs of Pauli measurements anticommute with each other.

According to this aspect, the controller may be configured to compute the error metric value as a maximum of one or more first assignment error probabilities computed in a first Pauli basis, one or more second assignment error probabilities computed in a second Pauli basis, one or more first mutual unbiasedness values computed for a first ordering of non-commuting Pauli measurements, and one or more second mutual unbiasedness values computed for a second ordering of the non-commuting Pauli measurements. The above features may have the technical effect of incorporating both the assignment error probabilities and the mutual unbiasedness values into a single error metric.

According to this aspect, the controller may be further configured to set the Majorana island to an idle configuration between adjacent Pauli measurements in the Pauli measurement sequence. The above features may have the technical effect of increasing the independence of the Pauli measurements in the Pauli measurement sequence.

According to another aspect of the present disclosure, a computing system is provided, including a quantum computing device. The quantum computing device includes a plurality of logical qubits that each include a respective plurality of physical qubits. The computing system further includes a controller configured to determine an error metric value of a qubit error metric for a logical qubit of the plurality of logical qubits. The controller is configured to determine the error metric value at least in part by, at the logical qubit, performing a Pauli measurement sequence including a plurality of Pauli measurements. The controller is further configured to compute the error metric value based at least in part on respective results of the plurality of Pauli measurements. Computing error metric value includes computing respective assignment error probabilities of the Pauli measurements, and/or computing respective mutual unbiasedness values of pairs of non-commuting Pauli measurements that are adjacent in the Pauli measurement sequence. The controller is further configured to output the error metric value. The above features may have the technical effect of determining the error properties of the logical qubits.

According to this aspect, the controller may be further configured to control the physical qubits included in the logical qubit based at least in part on the error metric value. The above features may have the technical effect of programmatically modifying properties of the physical qubits in a manner that decreases the logical error rate of a quantum computation.

According to this aspect, the controller may be further configured to determine respective physical-qubit error metric values of the physical qubits included in the logical qubit. The controller may be further configured to control the physical qubits based at least in part on the physical-qubit error metric values. The above features may have the technical effect of programmatically modifying properties of the physical qubits to achieve a lower physical error rate.

According to this aspect, the Pauli measurements included in the Pauli measurement sequence may each be randomly or pseudorandomly selected from between two non-commuting Pauli measurements. The above features may have the technical effect of selecting the sequence of Pauli measurements with which the error metric value is determined.

According to this aspect, the Pauli measurement sequence may be a predefined sequence of instances of non-commuting Pauli measurements. The above features may have the technical effect of selecting the sequence of Pauli measurements with which the error metric value is determined.

According to another aspect of the present disclosure, a method for use with a computing system, including a topological quantum computing device and a controller, is provided. The topological quantum computing device includes a plurality of Majorana islands that form a plurality of physical qubits. The method includes, for each of the physical qubits, determining an error metric value of a qubit error metric associated with the physical qubit in a measurement-based qubit benchmarking (MBQB) stage. The error metric value is determined at least in part by, at the Majorana island that forms the physical qubit, performing a Pauli measurement sequence including a plurality of Pauli measurements. Determining the error metric value further includes computing the error metric value based at least in part on respective results of the plurality of Pauli measurements. The method further includes outputting the error metric value. The above features may have the technical effect of determining the error properties of the physical qubits.

According to this aspect, the method may further include, in a Majorana parity readout (MPR) stage performed prior to the MBQB stage, for each of a plurality of measurement loops through the Majorana island, setting a plurality of loop parameters of that measurement loop to respective values within a resonance region. The above features may have the technical effect of achieving high measurement visibility for the Pauli measurements.

According to this aspect, each of the Majorana islands may include a plurality of superconductor-semiconductor junctions. The method may further include, in a topological gap protocol (TGP) stage performed prior to the MPR stage, setting a plurality of island parameters of the Majorana island to respective values within a topological region in which Majorana zero modes (MZMs) form adjacent to the superconductor-semiconductor junctions. The above features may have the technical effect of obtaining MZMs that are usable as the physical qubits.

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

The subject matter of the present disclosure includes all novel and non-obvious combinations and sub-combinations of the various processes, systems and configurations, and other features, functions, acts, and/or properties disclosed herein, as well as any and all equivalents thereof.

Clauses

The present disclosure provides the following Clauses:

Clause 1. A computing system comprising:

a topological quantum computing device including a plurality of Majorana islands that form a plurality of physical qubits; and
a controller configured to, for each of the physical qubits:

in a measurement-based qubit benchmarking, MBQB, stage, determine an error metric value of a qubit error metric associated with the physical qubit at least in part by:

at the Majorana island that forms the physical qubit, performing a Pauli measurement sequence including a plurality of Pauli measurements; and

computing the error metric value based at least in part on respective results of the plurality of Pauli measurements; and

output the error metric value.

Clause 2. The computing system of Clause 1, wherein, for each of the physical qubits, the controller is further configured to:
in a Majorana parity readout, MPR, stage performed prior to the MBQB stage, for each of a plurality of measurement loops through the Majorana island, set a plurality of loop parameters of that measurement loop to respective values within a resonance region.

Clause 3. The computing system of Clause 2, wherein:

each of the Majorana islands includes a plurality of superconductor-semiconductor junctions; and
the controller is further configured to, in a topological gap protocol, TGP, stage performed prior to the MPR stage, set a plurality of island parameters of the Majorana island to respective values within a topological region in which Majorana zero modes, MZMs, form adjacent to the superconductor-semiconductor junctions.

Clause 4. The computing system of Clause 3, wherein, for each of the one or more topological superconducting wires, the controller is further configured to:

obtain a non-topological error metric value at least in part by performing an additional MBQB stage for values of the island parameters that are outside the topological region;
based at least in part on the error metric value and the non-topological error metric value, compute a false positive rate of the error metric value;
based at least in part on the error metric value and the false positive rate, select respective values of one or more of the island parameters and/or the loop parameters for use in a quantum computation performed at the topological quantum computing device.

Clause 5. The computing system of any of Clauses 2 to 4, wherein the controller is further configured to:

determine that the error metric value is above a predefined error threshold; and
in response to determining that the error metric value is above the predefined error threshold, repeat the MPR stage and the MBQB stage.

Clause 6. The computing system of any of Clauses 2 to 5, wherein:

the resonance region is a region of a loop parameter space defined by:

a respective plurality of quantum dot, QD, voltages applied to respective QDs included in the Majorana island within the measurement loop; and
a respective plurality of cutter gate voltages of cutter gates included in the Majorana island; and

in the resonance region, one or more of the QDs included in the measurement loop are resonant with a topological superconducting wire included in the measurement loop.

Clause 7. The computing system of any preceding Clause, wherein:

a) the Pauli measurements included in the Pauli measurement sequence are each randomly or pseudorandomly selected from between two non-commuting Pauli measurements; or
b) the Pauli measurement sequence is a predefined sequence of instances of non-commuting Pauli measurements.

Clause 8. The computing system of any preceding Clause, wherein the controller is configured to compute the error metric value at least in part by computing respective assignment error probabilities of the Pauli measurements;
optionally wherein the controller is configured to compute the error metric value at least in part by computing respective mutual unbiasedness values of pairs of non-commuting Pauli measurements that are adjacent in the Pauli measurement sequence;
optionally wherein the controller is configured to compute the error metric value as a maximum of:

one or more first assignment error probabilities computed in a first Pauli basis;
one or more second assignment error probabilities computed in a second Pauli basis;
one or more first mutual unbiasedness values computed for a first ordering of non-commuting Pauli measurements; and
one or more second mutual unbiasedness values computed for a second ordering of the non-commuting Pauli measurements.

Clause 9. The computing system of any preceding Clause, wherein the controller is further configured to set the Majorana island to an idle configuration between adjacent Pauli measurements in the Pauli measurement sequence.

Clause 10. A computing system comprising:

a quantum computing device including a plurality of logical qubits that each include a respective plurality of physical qubits; and
a controller configured to:

determine an error metric value of a qubit error metric for a logical qubit of the plurality of logical qubits at least in part by:

at the logical qubit, performing a Pauli measurement sequence including a plurality of Pauli measurements; and
computing the error metric value based at least in part on respective results of the plurality of Pauli measurements, wherein computing error metric value includes:

computing respective assignment error probabilities of the Pauli measurements; and/or
computing respective mutual unbiasedness values of pairs of non-commuting Pauli measurements that are adjacent in the Pauli measurement sequence; and

output the error metric value.

Clause 11. The computing system of Clause 10, wherein the controller is further configured to control the physical qubits included in the logical qubit based at least in part on the error metric value;
optionally wherein the controller is further configured to:

determine respective physical-qubit error metric values of the physical qubits included in the logical qubit; and control the physical qubits based at least in part on the physical-qubit error metric values.

Clause 12. The computing system of Clause 10 or Clause 11, wherein:

a) the Pauli measurements included in the Pauli measurement sequence are each randomly or pseudorandomly selected from between two non-commuting Pauli measurements; or
b) the Pauli measurement sequence is a predefined sequence of instances of non-commuting Pauli measurements.

Clause 13. A method for use with a computing system including a topological quantum computing device and a controller, wherein the topological quantum computing device includes a plurality of Majorana islands that form a plurality of physical qubits, the method comprising, for each of the physical qubits:

in a measurement-based qubit benchmarking, MBQB, stage, determining an error metric value of a qubit error metric associated with the physical qubit at least in part by:

at the Majorana island that forms the physical qubit, performing a Pauli measurement sequence including a plurality of Pauli measurements; and
computing the error metric value based at least in part on respective results of the plurality of Pauli measurements; and

outputting the error metric value.

Clause 14. The method of Clause 13, further comprising:
in a Majorana parity readout, MPR, stage performed prior to the MBQB stage, for each of a plurality of measurement loops through the Majorana island, setting a plurality of loop parameters of that measurement loop to respective values within a resonance region.

Clause 15. The method of Clause 13 or Clause 14, wherein:

each of the Majorana islands includes a plurality of superconductor-semiconductor junctions; and
the method further comprises, in a topological gap protocol, TGP, stage performed prior to the MPR stage, setting a plurality of island parameters of the Majorana island to respective values within a topological region in which Majorana zero modes, MZMs, form adjacent to the superconductor-semiconductor junctions.

**Claims**

1. A computing system comprising:

a quantum computing device including a plurality of logical qubits that each include a respective plurality of physical qubits; and
a controller configured to:

determine an error metric value of a qubit error metric for a logical qubit of the plurality of logical qubits at least in part by:

at the logical qubit, performing a Pauli measurement sequence including a plurality of Pauli measurements; and
computing the error metric value based at least in part on respective results of the plurality of Pauli measurements, wherein computing error metric value includes:

computing respective assignment error probabilities of the Pauli measurements; and/or
computing respective mutual unbiasedness values of pairs of non-commuting Pauli measurements that are adjacent in the Pauli measurement sequence;

and output the error metric value.

2. The computing system of claim 1, wherein the controller is further configured to control the physical qubits included in the logical qubit based at least in part on the error metric value.

3. The computing system of claim 2, wherein the controller is further configured to:

determine respective physical-qubit error metric values of the physical qubits included in the logical qubit; and
control the physical qubits based at least in part on the physical-qubit error metric values.

4. The computing system of any preceding claim, wherein the Pauli measurements included in the Pauli measurement sequence are each randomly or pseudorandomly selected from between two non-commuting Pauli measurements.

5. The computing system of any of claims 1 to 3, wherein the Pauli measurement sequence is a predefined sequence of instances of non-commuting Pauli measurements.

6. A method for use with a computing system including a quantum computing device and a controller, wherein the topological quantum computing device includes a plurality of logical qubits that each include a respective plurality of physical qubits, the method comprising, at the controller:

determining an error metric value of a qubit error metric for a logical qubit of the plurality of logical qubits at least in part by:

at the logical qubit, performing a Pauli measurement sequence including a plurality of Pauli measurements; and
computing the error metric value based at least in part on respective results of the plurality of Pauli measurements, wherein computing error metric value includes:

computing respective assignment error probabilities of the Pauli measurements; and/or
computing respective mutual unbiasedness values of pairs of non-commuting Pauli measurements that are adjacent in the Pauli measurement sequence; and

outputting the error metric value.

7. The method according to claim 6, wherein the controller controls the physical qubits included in the logical qubit based at least in part on the error metric value.

8. The method of claim 7, wherein the controller:

determines respective physical-qubit error metric values of the physical qubits included in the logical qubit; and
controls the physical qubits based at least in part on the physical-qubit error metric values.

9. The method of any of claims 6 to 8, wherein the Pauli measurements included in the Pauli measurement sequence are each randomly or pseudorandomly selected from between two non-commuting Pauli measurements.

10. The method of any of claims 6 to 9, wherein the Pauli measurement sequence is a predefined sequence of instances of non-commuting Pauli measurements.

COMPUTING SYSTEM 1

TOPOLOGICAL QUANTUM COMPUTING DEVICE 10

LOGICAL QUBIT 14           LOGICAL QUBIT 14  •••

| MAJORANA ISLAND 12 | MAJORANA ISLAND 12 | ••• | MAJORANA ISLAND 12 | MAJORANA ISLAND 12 | ••• |

MEASUREMENT CIRCUITRY 16

QUANTUM CAPACITANCE SENSOR 18  •••

CONTROLLER 20

QUANTUM COMPUTING DEVICE I/O INTERFACE 30

MEASUREMENT RESULT 32  •••      CONTROL INSTRUCTIONS 34  •••   •••

PROCESSING DEVICE 22

MEMORY DEVICE 24  •••

FIG. 1

FIG. 2

FIG. 3

FIG. 4

EP 4 711 988 A2

FIG. 5

EP 4 711 988 A2

FIG. 6

FIG. 7

FIG. 8

1 ⟶

**CONTROLLER 20**

MEMORY DEVICE 24  •••

PROCESSING DEVICE 22

**MAJORANA PARITY READOUT STAGE 120**

LOOP PARAMETERS 122

QD VOLTAGE 124  •••

CUTTER GATE VOLTAGE 126  •••

MAGNETIC FIELD 106

LOOP PARAMETER SPACE 130

RESONANCE REGION 132

QD VOLTAGE RESONANCE VALUE 134  •••

CUTTER GATE VOLTAGE RESONANCE VALUE 136  •••

IDLE CONFIGURATION 133

QD VOLTAGE IDLE VALUE 135  •••

CUTTER GATE VOLTAGE IDLE VALUE 137  •••

•••

MEASUREMENT CIRCUITRY 16

**MEASUREMENT LOOP 138**

SUPERCONDUCTOR-SEMICONDUCTOR JUNCTION 44

SUPERCONDUCTOR-SEMICONDUCTOR JUNCTION 44  •••

•••

QD 48

QD 48  •••

CUTTER GATE 52

CUTTER GATE 52  •••

MAJORANA ISLAND 12

TOPOLOGICAL QUANTUM COMPUTING DEVICE 10

FIG. 9

1

**CONTROLLER 20**

MEMORY DEVICE 24 •••

RANDOM NUMBER GENERATOR 150

PREDEFINED SEQUENCE 151

PAULI MEASUREMENT SEQUENCE 142 (RANDOM, PSEUDORANDOM, OR PREDEFINED SEQUENCE)

IN 1ST PAULI BASIS 146

PAULI MEASUREMENT 144

RESET TO IDLE CONFIGURATION 133

IN 2ND PAULI BASIS 148

PAULI MEASUREMENT 144

RESET TO IDLE CONFIGURATION 133

PAULI MEASUREMENT 144

RESET TO IDLE CONFIGURATION 133

MEASUREMENT-BASED QUBIT BENCHMARKING STAGE 140

PAULI MEASUREMENT 144

⋮

PROCESSING DEVICE 22

MEASUREMENT CIRCUITRY 16

MAJORANA ISLAND 12 •••

TOPOLOGICAL QUANTUM COMPUTING DEVICE 10

FIG. 10A

1 ⟍

CONTROLLER 20

MEMORY DEVICE 24 •••

PROCESSING DEVICE 22

MEASUREMENT-BASED QUBIT
BENCHMARKING STAGE 140

PAULI MEASUREMENT DATA 160

MEASUREMENT RESULT 162

MEASUREMENT RESULT 162

⋮

QUBIT ERROR METRIC 164

ASSIGNMENT ERROR
PROBABILITY 166

MUTUAL UNBIASEDNESS
VALUE 168

ERROR METRIC VALUE 170

PAIR 171 OF
COMMUTING PAULI
MEASUREMENTS

144   144

PAIR 172 OF NON-
COMMUTING PAULI
MEASUREMENTS

144   144

•••

MEASUREMENT CIRCUITRY 16

MAJORANA ISLAND 12   •••

TOPOLOGICAL QUANTUM COMPUTING DEVICE 10

FIG. 10B

CONTROLLER 20

MEMORY DEVICE 24 • • •

PAULI MEASUREMENT DATA 160

PAULI MEASUREMENT SEQUENCE 142

1ST ASSIGNMENT ERROR PROBABILITY 166A

PAIR 171A OF COMMUTING PAULI MEASUREMENTS

144      144

2ND ASSIGNMENT ERROR PROBABILITY 166B

PAIR 171B OF COMMUTING PAULI MEASUREMENTS

144      144

IN 1ST PAULI BASIS 146

IN 2ND PAULI BASIS 148

1ST MUTUAL UNBIASEDNESS VALUE 168A

PAIR 172A OF NON-COMMUTING PAULI MEASUREMENTS

144      144

1ST ORDERING 174A

2ND MUTUAL UNBIASEDNESS VALUE 168B

PAIR 172B OF NON-COMMUTING PAULI MEASUREMENTS

144      144

2ND ORDERING 174A

QUBIT ERROR METRIC 164: MAXIMUM

ERROR METRIC VALUE 170

PROCESSING DEVICE 22

FIG. 11

FIG. 12A

1

CONTROLLER 20

MEMORY DEVICE 24 • • •

ADDITIONAL MBQB STAGE 180

PAULI MEASUREMENT SEQUENCE 142

NON-TOPOLOGICAL REGION MEASUREMENT DATA 188

MEASUREMENT RESULT 162

MEASUREMENT RESULT 162

⋮

ERROR METRIC VALUE 170

NON-TOPOLOGICAL ERROR METRIC VALUE 190

FALSE POSITIVE RATE 192

ERROR WEIGHTING FUNCTION 195

INSTRUCTIONS TO PERFORM QUANTUM COMPUTATION 194

ISLAND PARAMETERS 102

LOOP PARAMETERS 122

PROCESSING DEVICE 22

• • •

MEASUREMENT CIRCUITRY 16

FIG. 12B

MAJORANA ISLAND 12 • • •

TOPOLOGICAL QUANTUM COMPUTING DEVICE 10

1

**CONTROLLER 20**

MEMORY DEVICE 24 • • •

TOPOLOGICAL GAP
PROTOCOL STAGE 100

IN 1ST PAULI
BASIS 146

MAJORANA PARITY READOUT STAGES 120

FOR FIRST MEASUREMENT LOOP 138A

FOR SECOND MEASUREMENT LOOP 138B

IN 2ND PAULI
BASIS 148

MEASUREMENT-BASED QUBIT
BENCHMARKING STAGE 140

ERROR METRIC VALUE 170

• • •

PREDEFINED ERROR
THRESHOLD 196

ABOVE
THRESHOLD?

YES

NO

PROCESSING
DEVICE 22

INSTRUCTIONS TO PERFORM
QUANTUM COMPUTATION 194

**FIG. 13**

MEASUREMENT CIRCUITRY 16

MAJORANA ISLAND 12 • • •

TOPOLOGICAL QUANTUM COMPUTING DEVICE 10

COMPUTING SYSTEM 200

QUANTUM COMPUTING DEVICE 210

LOGICAL QUBIT 214

PHYSICAL QUBIT 212   PHYSICAL QUBIT 212   •••

LOGICAL QUBIT 214

PHYSICAL QUBIT 212   PHYSICAL QUBIT 212   •••

•••

MEASUREMENT CIRCUITRY 216

MEASUREMENT-BASED QUBIT BENCHMARKING STAGE 230

RANDOM NUMBER GENERATOR 236

PREDEFINED SEQUENCE 238

IN 1ST PAULI BASIS 146

PAULI MEASUREMENT SEQUENCE 232

PAULI MEASUREMENT 234

PAULI MEASUREMENT 234

IN 2ND PAULI BASIS 148

⋮

PAULI MEASUREMENT DATA 240

MEASUREMENT RESULT 242

MEASUREMENT RESULT 242

⋮

•••

PROCESSING DEVICE 222

CONTROLLER 220

MEMORY DEVICE 224   •••

FIG. 14A

COMPUTING SYSTEM 200

QUANTUM COMPUTING DEVICE 210

LOGICAL QUBIT 214

PHYSICAL QUBIT 212    PHYSICAL QUBIT 212   •••

LOGICAL QUBIT 214

PHYSICAL QUBIT 212    PHYSICAL QUBIT 212   •••

•••

MEASUREMENT CIRCUITRY 216

PROCESSING DEVICE 222

MEASUREMENT-BASED QUBIT BENCHMARKING STAGE 230

PAIR 249 OF COMMUTING PAULI MEASUREMENTS

234    234

PAULI MEASUREMENT DATA 240

ASSIGNMENT ERROR PROBABILITY 246

MUTUAL UNBIASEDNESS VALUE 248

QUBIT ERROR METRIC 244

PAIR 250 OF NON-COMMUTING PAULI MEASUREMENTS

234    234

•••

ERROR METRIC VALUE 252

PHYSICAL-QUBIT ERROR METRIC VALUE 256   •••

CONTROL INSTRUCTIONS 254

CONTROLLER 220

MEMORY DEVICE 224   •••

FIG. 14B

300 ⟶

SETTING A PLURALITY OF ISLAND PARAMETERS OF THE MAJORANA ISLAND TO RESPECTIVE VALUES WITHIN A TOPOLOGICAL REGION IN WHICH MAJORANA ZERO MODES (MZMS) FORM ADJACENT TO THE SUPERCONDUCTOR-SEMICONDUCTOR JUNCTIONS  302

IN A MAJORANA PARITY READOUT (MPR) STAGE, FOR EACH OF A PLURALITY OF MEASUREMENT LOOPS THROUGH A MAJORANA ISLAND, SETTING A PLURALITY OF LOOP PARAMETERS OF THAT MEASUREMENT LOOP TO RESPECTIVE VALUES WITHIN A RESONANCE REGION  304

PERFORMING THE MPR STAGE FOR A FIRST MEASUREMENT LOOP AND A SECOND MEASUREMENT LOOP CORRESPONDING TO A FIRST PAULI BASIS AND A SECOND PAULI BASIS  306

IN A MEASUREMENT-BASED QUBIT BENCHMARKING (MBQB) STAGE, DETERMINING AN ERROR METRIC VALUE OF A QUBIT ERROR METRIC FOR THE MAJORANA ISLAND  308

AT THE MAJORANA ISLAND, PERFORMING A PAULI MEASUREMENT SEQUENCE INCLUDING A PLURALITY OF PAULI MEASUREMENTS  310

COMPUTING THE ERROR METRIC VALUE BASED AT LEAST IN PART ON RESPECTIVE RESULTS OF THE PLURALITY OF PAULI MEASUREMENTS  312

OUTPUTTING THE ERROR METRIC VALUE  314

FIG. 15A

IDENTIFYING AN IDLE CONFIGURATION OF THE LOOP PARAMETERS — 316

SETTING THE MAJORANA ISLAND TO THE IDLE CONFIGURATION BETWEEN ADJACENT PAULI MEASUREMENTS IN THE PAULI MEASUREMENT SEQUENCE — 318

FIG. 15B

RANDOMLY OR PSEUDORANDOMLY SELECTING THE PAULI MEASUREMENTS INCLUDED IN THE PAULI MEASUREMENT SEQUENCE FROM BETWEEN TWO NON-COMMUTING PAULI MEASUREMENTS — 320

SELECTING THE PAULI MEASUREMENT SEQUENCE AS A PREDEFINED SEQUENCE OF INSTANCES OF NON-COMMUTING PAULI MEASUREMENTS — 322

FIG. 15C

COMPUTING THE ERROR METRIC VALUE AT LEAST IN PART BY COMPUTING RESPECTIVE ASSIGNMENT ERROR PROBABILITIES OF THE PAULI MEASUREMENTS — 324

COMPUTING THE ERROR METRIC VALUE AT LEAST IN PART BY COMPUTING RESPECTIVE MUTUAL UNBIASEDNESS VALUES OF PAIRS OF NON-COMMUTING PAULI MEASUREMENTS THAT ARE ADJACENT IN THE PAULI MEASUREMENT SEQUENCE — 326

COMPUTING THE ERROR METRIC VALUE AS A MAXIMUM OF ONE OR MORE FIRST ASSIGNMENT ERROR PROBABILITIES COMPUTED IN A FIRST PAULI BASIS, ONE OR MORE SECOND ASSIGNMENT ERROR PROBABILITIES COMPUTED IN A SECOND PAULI BASIS, ONE OR MORE FIRST MUTUAL UNBIASEDNESS VALUES COMPUTED FOR A FIRST ORDERING OF NON-COMMUTING PAULI MEASUREMENTS, AND ONE OR MORE SECOND MUTUAL UNBIASEDNESS VALUES COMPUTED FOR A SECOND ORDERING OF THE NON-COMMUTING PAULI MEASUREMENTS — 328

# FIG. 15D

OBTAINING A NON-TOPOLOGICAL ERROR METRIC VALUE AT LEAST IN PART BY PERFORMING AN ADDITIONAL MBQB STAGE FOR VALUES OF THE ISLAND PARAMETERS THAT ARE OUTSIDE THE TOPOLOGICAL REGION — 330

BASED AT LEAST IN PART ON THE ERROR METRIC VALUE AND THE NON-TOPOLOGICAL ERROR METRIC VALUE, COMPUTING A FALSE POSITIVE RATE OF THE ERROR METRIC VALUE — 332

BASED AT LEAST IN PART ON THE ERROR METRIC VALUE AND THE FALSE POSITIVE RATE, SELECTING RESPECTIVE VALUES OF ONE OR MORE OF THE ISLAND PARAMETERS AND/OR THE LOOP PARAMETERS FOR USE IN A QUANTUM COMPUTATION PERFORMED AT THE TOPOLOGICAL QUANTUM COMPUTING DEVICE — 334

## FIG. 15E

DETERMINING THAT THE ERROR METRIC VALUE IS ABOVE A PREDEFINED ERROR THRESHOLD — 336

IN RESPONSE TO DETERMINING THAT THE ERROR METRIC VALUE IS ABOVE THE PREDEFINED ERROR THRESHOLD, REPEAT THE MPR STAGE AND THE MBQB STAGE — 338

## FIG. 15F

400 ⟍

402

DETERMINING AN ERROR METRIC VALUE OF A QUBIT ERROR METRIC FOR A
LOGICAL QUBIT OF A PLURALITY OF LOGICAL QUBITS INCLUDED IN A QUANTUM
COMPUTING DEVICE

404

AT THE LOGICAL QUBIT, PERFORMING A PAULI MEASUREMENT SEQUENCE
INCLUDING A PLURALITY OF PAULI MEASUREMENTS

406

COMPUTING THE ERROR METRIC VALUE BASED AT LEAST IN PART ON
RESPECTIVE RESULTS OF THE PLURALITY OF PAULI MEASUREMENTS

408

COMPUTING RESPECTIVE ASSIGNMENT ERROR PROBABILITIES OF THE
PAULI MEASUREMENTS

410

COMPUTING RESPECTIVE MUTUAL UNBIASEDNESS VALUES OF PAIRS OF
NON-COMMUTING PAULI MEASUREMENTS THAT ARE ADJACENT IN THE
PAULI MEASUREMENT SEQUENCE

412

OUTPUTTING THE ERROR METRIC VALUE

414

CONTROLLING THE PHYSICAL QUBITS INCLUDED IN THE LOGICAL QUBIT BASED
AT LEAST IN PART ON THE ERROR METRIC VALUE

FIG. 16A

416

DETERMINING RESPECTIVE PHYSICAL-QUBIT ERROR METRIC VALUES OF THE
PHYSICAL QUBITS INCLUDED IN THE LOGICAL QUBIT

418

CONTROLLING THE PHYSICAL QUBITS BASED AT LEAST IN PART ON THE
PHYSICAL-QUBIT ERROR METRIC VALUES

FIG. 16B

COMPUTING SYSTEM 500

PROCESSING CIRCUITRY 502

VOLATILE MEMORY 504

NON-VOLATILE STORAGE DEVICE 506

DISPLAY SUBSYSTEM 508

INPUT SUBSYSTEM 510

COMMUNICATION SUBSYSTEM 512

FIG. 17